(19) Europäisches Patentamt
European Patent Office
Office européen des brevets

(11) EP 1 630 199 A1

(12) **EUROPEAN PATENT APPLICATION**
published in accordance with Art. 158(3) EPC

(43) Date of publication:
**01.03.2006 Bulletin 2006/09**

(21) Application number: **04734352.0**

(22) Date of filing: **21.05.2004**

(51) Int Cl.:
***C08L 63/00*** *(1985.01)*

(86) International application number:
**PCT/JP2004/006943**

(87) International publication number:
**WO 2004/104097 (02.12.2004 Gazette 2004/49)**

(84) Designated Contracting States:
**AT BE BG CH CY CZ DE DK EE ES FI FR GB GR HU IE IT LI LU MC NL PL PT RO SE SI SK TR**

(30) Priority: **22.05.2003 JP 2003145423**

(71) Applicant: **Asahi Kasei Chemicals Corporation**
**Tokyo 100-8440 (JP)**

(72) Inventors:
- **UCHIDA, Hiroshi;**
**Yokohama-shi,**
**Kanagawa 2440816 (JP)**
- **ONIZUKA, Kenzo;**
**Kawasaki-shi,**
**Kanagawa 2100823 (JP)**
- **TAKADA, Yoshihiko;**
**Yokohama-shi, Kanagawa 2230055 (JP)**
- **TOKIWA, Tetsuji**
**Chiba 2990261 (JP)**

(74) Representative: **HOFFMANN EITLE**
**Patent- und Rechtsanwälte**
**Arabellastrasse 4**
**81925 München (DE)**

# (54) EPOXY RESIN COMPOSITION

(57) The present invention relates to an epoxy resin composition comprising a polyphenylene ether having a number average molecular weight of 1,000, to 4,000 and containing components having a molecular weight of 20,000 or more in an amount of substantially 20% or less, and an epoxy resin. The present invention further relates to an epoxylated polyphenylene ether resin obtained by reacting a phenolic hydroxyl group of a polyphenylene ether having a number average molecular weight of 1,000 to 4,000 with an epoxy group of an epoxy compound or an epoxy resin.

EP 1 630 199 A1

**Description**

TECHNICAL FIELD

The present invention relates to an epoxy resin composition containing a polyphenylene ether, useful as an insulating material for a printed wiring board and the like; a solution of the epoxy resin composition; a varnish having the epoxy resin composition in an organic solvent; a prepreg; which is a substrate impregnated with the varnish; a laminate board using the prepreg; a curable resin/metal foil composite formed of the epoxy resin composition containing polyphenylene ether and a metal foil; a film containing a curable epoxy resin composition; and a printed wiring board and an electronic device using these.

BACKGROUND ART

An epoxy resin excellent in cost performance is widely used as an insulating material for printed wiring boards. To satisfy the recent requirement for increasing the density of wiring, higher performance of an epoxy resin has been desired. For example, in a printed wiring board used in a high frequency region, such as satellite communications, an insulating material excellent in dielectric characteristics, that is, having a low dielectric constant and a low dielectric tangent, is required for preventing signal delay. To satisfy such a requirement, an epoxy resin composition containing polyphenylene ether has been proposed. It is known that the resultant laminate board shows excellent dielectric characteristics. Furthermore, as disclosed in JP-A-58-219217 and JP-A-09-291148, a polyphenylene ether having improved physical properties such as processability and adhesion properties, which is obtained by incorporating an epoxy group into the polyphenylene ether so as to reduce the melt viscosity of the resin, is known.

A laminate board is generally formed by impregnating a substrate such as glass fiber with a resin solution (varnish), followed by drying it to prepare a prepreg, laminating the prepreg and a metal foil such as copper foil, and heating the laminate under pressure. As desclosed in JP-A-58-219217 and JP-A-09-291148, examples of a solvent for preparing a varnish from an epoxy resin composition containing a polyphenylene ether include a solvent capable of dissolving a polyphenylene ether, and more specifically include halogen solvents such as dichloromethane and chloroform and aromatic solvents such as benzene, toluene and xylene. These solvents may be used singly or in the form of a mixture of two or more types.

However, the use of such a halogen solvent tends to be limited in fear of environmental effects. On the other hand, the use of toluene as an aromatic solvent may cause gelation of a polyphenylene ether. To prevent the gelation, it is necessary to impregnate a substrate with a varnish, while keeping it at high temperatures. Therefore, it has been pointed out that such an aromatic solvent may interfere with forming of a prepreg.

DISCLOSURE OF THE INVENTION

An object of the present invention is to provide an epoxy resin composition capable of solving the aforementioned problems and having a satisfactory long-term stability to a ketone generally used in forming a prepreg, excellent processability, high adhesion properties and heat resistance successfully preventing a phase separation in a curing process, and excellent dielectric characteristics.

The present inventors have conducted intensive studies to solve the aforementioned object. As a result, they have found that the use of a polyphenylene ether having a predetermined molecular weight enables a ketone to be used as a solvent of a varnish. Furthermore, they have surprisingly found that the solubility of the polyphenylene ether having the predetermined molecular weight in a ketone can be remarkably stabilized by epoxylating the polyphenylene ether. Moreover, they have found that the addition of a multifunctional epoxy resin to an epoxy resin to be modified overcomes a problem of a phase separation taking place in the curing process and tremendously improves the physical properties of the resultant laminate board and film.

In addition, they have found that the processability can be dramatically improved by containing at least one of a cage-form silsesquioxane and a partially cleaved cage-form silsesquioxane. The present invention has been achieved based on the findings mentioned above.

More specifically, the aspects of the present invention are as follows.

(1) An epoxy resin composition comprising a polyphenylene ether having a number average molecular weight of 1,000 to 4,000 and containing components having a molecular weight of 20,000 or more determined by GPC (gel permeation chromatography) in an amount of substantially 20% or less, and an epoxy resin.

(2) An epoxy resin composition comprising a polyphenylene ether having a number average molecular weight of 1,000 to 4,000 and substantially free of components having a molecular weight of 20,000 or more determined by GPC, and an epoxy resin.

(3) An epoxy resin composition comprising a polyphenylene ether having a number average molecular weight of 1,000 to 4,000 and substantially free of components having a molecular weight of 300 or less determined by GPC, and an epoxy resin.

(4) An epoxy resin composition comprising a polyphenylene ether having a number average molecular weight of 1,000 to 4,000 and substantially free of either components of a molecular weight of 20,000 or more or of 300 or less determined by GPC, and an epoxy resin.

(5) The epoxy resin composition according to any one of the above items 1 to 4, in which the polyphenylene ether comprises not less than 1.2 phenolic hydroxyl groups per molecule in average.

(6) The epoxy resin composition according to any one of the above items 1 to 5, in which the epoxy resin contains a multifunctional epoxy resin in an amount of 5% by mass or more.

(7) A ketone solution of an epoxy resin composition comprising the epoxy resin composition according to any one of the above items 1 to 6 in an amount of 10% by mass or more and substantially no solid matter at room temperature.

(8) An epoxylated polyphenylene ether resin obtained by reacting a phenolic hydroxyl group of a polyphenylene ether having a number average molecular weight of 1,000 to 4,000 with an epoxy group of an epoxy compound or an epoxy resin.

(9) An epoxylated polyphenylene ether resin having not less than 3 epoxy groups per molecule in average.

(10) An epoxylated polyphenylene ether resin having a number average molecular weight of 3,200 to 10,000.

(11) An epoxylated polyphenylene ether resin having a polyphenylene ether skeleton in a proportion of 30% by mass to 90% by mass.

(12) The epoxylated polyphenylene ether resin according to the above item 10 or 11, having not less than 3 epoxy groups per molecule in average.

(13) The epoxylated polyphenylene ether resin according to the above item 11, having a number average molecular weight of 3,200 to 10,000.

(14) An epoxylated polyphenylene ether resin having not less than 3 epoxy groups per molecule in average, a number average molecular weight of 3,200 to 10,000, and a polyphenylene ether skeleton in a proportion of 30% by mass to 90% by mass.

(15) The epoxylated polyphenylene ether resin according to any one of the above items 8 to 14, in which a phenolic hydroxyl group of the epoxylated polyphenylene ether resin is 10 meq/kg or less.

(16) An epoxy resin composition comprising the epoxylated polyphenylene ether resin according to any one of the above items 8 to 14 and an epoxy resin.

(17) An epoxy resin composition comprising the epoxylated polyphenylene ether resin according to any one of the above items 8 to 14 and an epoxy resin, and being soluble in a ketone.

(18) A ketone solution of an epoxy resin composition comprising the epoxy resin composition according to the above item 16 in an amount of 10% by mass or more and substantially by no solid matter at room temperature.

(19) The epoxy resin composition according to the above item 16, comprising the epoxylated polyphenylene ether resin in an amount of 25% by mass or more.

(20) An epoxy resin composition comprising the epoxy resin composition according to the above item 16 and, as a flame resistant agent, at least one selected from the group consisting of brominated epoxy resins, phosphazene compounds containing an epoxy group, phosphate esters, condensed phosphate esters, and quinine derivatives of a phosphine compound.

(21) The epoxy resin composition according to the above item 20, comprising the epoxylated polyphenylene ether resin in an amount of 40 to 90% by mass, the flame resistant agent in an amount of 10 to 50% by mass, and the epoxy resin in an amount of 0.1 to 30% by mass.

(22) The epoxy resin composition according to the above item 20 or 21, in which the epoxy resin includes an epoxy resin having an oxazolidone ring.

(23) The epoxy resin composition according to any one of the above items 1 to 7, 16, and 19 to 22, further comprising at least one of a cage-form silsesquioxane and a partially cleaved cage-form silsesquioxane.

(24) The epoxy resin composition according to any one of the above items 1 to 7, 16, and 19 to 22, further comprising a curing agent for the epoxy resin.

(25) A cured product comprising the epoxy resin composition according to the above item 24 being homogeneous and having substantially no phase separation.

(26) An epoxy resin composition comprising the epoxylated polyphenylene ether resin according to any one of the above items 8 to 14 and further a curing agent for the epoxy resin.

(27) An electronic member comprising the epoxy resin composition according to the above items 1 to 7, 16, 17, and 19 to 25 selected from the group consisting of a resin varnish, prepreg, curable resin/metal foil composite, film, laminate board, multilayer printed wiring board, sealing resin composition, and curable resin composition for an adhesive agent.

(28) An electronic member comprising the epoxylated polyphenylene ether resin according to any one of the above

items 8 to 14 selected from a resin varnish, prepreg, curable resin/metal foil composite, film, laminate board, multilayer printed wiring board, sealing resin composition, and curable resin composition for an adhesive agent.
(29) An electronic apparatus comprising the electronic member according to the above item 27 or 28.
(30) A method of producing an epoxylated polyphenylene ether resin comprising reacting a phenolic hydroxyl group of a polyphenylene ether having a number average molecular weight of 1,000 to 4,000 with an epoxy group of an epoxy compound or an epoxy resin.

According to the present invention, an epoxy resin composition containing a polyphenylene ether having a specific molecular weight is excellent in heat resistance, dielectric characteristics, processability, and adhesion properties and can be provided in the form of a stable ketone solution at room temperature. Furthermore, the use of the epoxy resin composition provides a laminate board having excellent dielectric characteristics.

BEST MODE FOR CARRYING OUT THE INVENTION

Now, the present invention will be described in detail.
The polyphenylene ether resin to be used in the present invention has a number average molecular weight limited to the range of 1,000 to 4,000 and contains components having a molecular weight of 20,000 or more in an amount of substantially 20% or less. The phrase "containing components having a molecular weight of 20,000 or more in an amount of substantially 20% or less" means that the peak area of components having a molecular weight of 20,000 or more determined by gel permeation chromatography is 20% or less. The phrase "substantially free of components having a molecular weight of 20,000 or more" means that the molecular weight at the start of peak detection is 20,000 or less in gel permeation chromatography.
The polyphenylene ether resin to be used in the present invention is limited in number average molecular weight to 1,000 to 4,000, and substantially free of components having a molecular weight of 300 or less. The phrase "substantially free of components having a molecular weight of 300 or less" means that the molecular weight at the completion of peak detection is 300 or more in gel permeation chromatography.
The number average molecular weight of the polyphenylene ether resin to be used in the present invention is limited within the range of 1,000 to 4,000, preferably 1,500 to 4,000, more preferably 2,000 to 4,000, and further preferably 2,400 to 4,000. When the number average molecular weight is 4,000 or less, a resin composition has a low melt viscosity and good processability. When the number average molecular weight is 1,000 or more, it is possible to prevent the dielectric constant of a resin composition from increasing. The higher the average number molecular weight within the range of 1,000 to 4,000, the higher the effect of preventing an increase in dielectric constant of a resin composition.
Since a polyethylene ether resin contains components having a molecular weight of 20,000 or more in an amount of substantially 20% or less, the resin shows good solubility in a ketone solvent such as acetone or methylethyl ketone, making it possible to prepare a varnish using a ketone solvent. More preferably, components having a molecular weight of 20,000 or more are substantially not present, further preferably that components having a molecular weight of 10,000 or more are substantially not present. When these conditions exist, the solubility of a polyphenylene ether resin in a ketone can be maintained stably for a long time.
Furthermore, since the polyphenylene ether resin contains substantially no components having a molecular weight of 300 or less, the heat resistance of a resin composition can be improved while preventing an increase of dielectric constant.
For example, polyphenylene ether resin has a structural unit represented by the following formula (1). A specific example of the resin is poly (2,6-dimethyl-1,4-phenylene oxide).

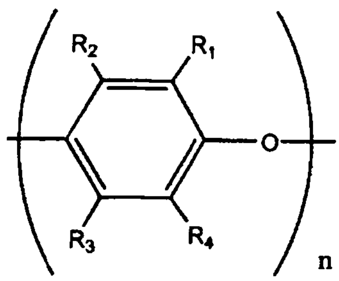

(1)

wherein n represents a positive integer; $R_1$, $R_2$, $R_3$ and $R_4$ represent hydrogen or a hydrocarbon having 1 to 3 carbon atoms; and $R_1$, $R_2$, $R_3$ and $R_4$ may be the same or different.

A polyphenylene ether resin is generally produced by a polymerization reaction. The phrase "produced by a polymerization reaction" refers to a method in which a phenolic compound is polymerized by oxidation in the presence of a copper catalyst or an amine catalyst by use of an oxygen-containing gas, as disclosed in U.S. Patent No. 4059568. However, the polyphenylene ether resin obtained by this method has a number average molecular weight of 10,000 to 30,000.

A polyphenylene ether resin having a number average molecular weight within the range of 1,000 to 4,000 according to the present invention is prepared by providing a commercially available polyphenylene ether having a large number average molecular weight as described above and adjusting its number average molecular weight to the aforementioned range. The adjustment of the molecular weight of the polyphenylene ether resin is shown in a scientific literature, Journal of Organic Chemistry, 34, 297-303 (1968). More specifically, a polyphenylene ether resin having a large number average molecular weight can be reacted with a polyphenolic compound such as a bisphenol A, tetramethyl bisphenol A, tetramethyl biphenyl, dihydroxydiphenyl ether, phenol novorak, or cresol novorak in the presence of a radical initiator. In the reaction, the polyphenylene ether resin is redistributed and reduced in molecular weight, with the result that a polyphenylene ether resin having a number average molecular weight within the range of 1,000 to 4,000 can be obtained.

Examples of such a radical initiator include peroxide compounds such as dicumyl peroxide, tert-butyl cumyl peroxide, di-tert-butyl peroxide, 2,5-dimethyl-2,5-di-tert-butyl cumyl peroxyhexyne-3,2,5-dimethyl-2,5-di-tert-butyl peroxyhexane, $\alpha,\alpha'$-bis(tert-butylperoxy-m-isopropyl)benzene (also referred to as 1,4(or 1,3)-bis(tert-butylperoxyisopropyl) benzene) and benzoyl peroxide.

The polyphenylene ether having a number average molecular weight of 1,000 to 4,000 may also be prepared by performing a general polyphenylene ether preparation method and terminating the reaction in the middle when its polymerization degree is still low. Alternatively, the polyphenylene ether can be efficiently prepared by using a solvent mixture of not less than two types of alcohols and a predetermined amine compound serving as a catalyst.

To obtain a polyphenylene ether substantially free of components having a molecular weight of 20,000 or more, the above-described redistribution reaction must be efficiently performed. For example, after the first redistribution reaction, the redistribution reaction can be completed by adding a radical initiator and/or a polyphenolic compound thereto. Alternatively, after the obtained polyphenylene ether having a number average molecular weight of 1,000 to 4,000 is dissolved in a ketone such as methylethyl ketone or acetone, insoluble matters can be simply removed by means of filtration.

In order that a polyphenylene ether does not comprise components having a molecular weight of 300 or less substantially, for example, a polyphenylene ether having a number average molecular weight of 1,000 to 4,000 may be washed with a solvent such as methanol.

A phenolic hydroxyl group of the obtained polyphenylene ether is contained in a proportion of not less than 1.2, more preferably not less than 1.4, and further preferably not less than 1.6 per molecule. When the amount of phenolic hydroxyl group is low, a failure of cross-linking occurs in a curing process. As a result, the resin is not uniformly cured.

The polyphenylene ether having a phenolic hydroxyl group in a proportion of not less than 1.2 per molecule can be prepared by reacting a polyphenylene ether with a polyphenolic compound to perform a redistribution reaction, as described above. Alternatively, in a general polyphenylene ether preparation method, a polyphenol compound such as bisphenol A, tetramethyl bisphenol A, tetramethyl biphenyl, dihydroxydiphenyl ether, phenol novorak, or cresol novorak may be used as a starting material.

The epoxy compound to be used in the present invention refers to a halogenated glycidyl such as epichlorohydrin. The epoxy resin to be used in the present invention is one having not less than two epoxy groups within a molecule. Example of such an epoxy resin include a bisphenol A-type epoxy resin, a bisphenol F-type epoxy resin, a bisphenol S-type epoxy resin, a hydantoin-type epoxy resin, a biphenyl-type epoxy resin, an alicyclic epoxy resin, a triphenyl methane type epoxy resin, a phenol-novorak type epoxy resin, a cresol-novorak type epoxy resin, and halogenated products of these epoxy resins.

The multifunctional epoxy resin to be used in the present invention refers to an epoxy resin having not less than 3 epoxy groups within a molecule. Any multifunctional epoxy resin may be used as long as it contains not less than 3 epoxy groups within a molecule. Examples of such a multifunctional epoxy resin include a phenol-novorak type epoxy resin, a cresol-novorak type epoxy resin, a naphthol novorak-type epoxy resin, a bis-A novorak type epoxy resin, a dicyclopentadiene/phenol epoxy resin, an aliphatic amine epoxy resin, and an aliphatic amine epoxy resin. They may be used singly or in the form of a mixture of two types or more. The multifunctional epoxy resin shown above is preferably contained in an amount of 5% by mass or more, preferably 10% by mass or more, and more preferably 20% by mass or more of the total amount of the epoxy resin. If the amount of the multifunctional epoxy resin is less than 5% by mass, the cured resin causes phase separation. As a result, a laminate board or a film formed of such a cured resin is inferior in adhesiveness and heat resistance to those formed of a cured resin containing the multifunctional epoxy resin in an amount of 5% by mass or more.

The epoxylated polyphenylene ether resin of the present invention preferably contains, in average, not less

than 3 epoxy groups, and more preferably, not less than 5 epoxy groups with a molecule. If not less than 3 epoxy groups in average is present within a molecule, such a resin shows excellent compatibility with another epoxy resin. In addition, since the resin is cured at a high rate and integrated into a cross-linking structure of the other epoxy resin, no phase separation takes place. Furthermore, since a number of polar groups are contained in a molecule, the resin is readily dissolved in a polar solvent such as a ketone solution. The epoxylated polyphenylene ether resin contains an epoxylated polyphenylene ether.

In the present invention, the polyphenylene ether skeleton contained in the epoxylated polyphenylene ether resin is preferably 30 to 90% by mass, more preferably 40 to 80% by mass, and further preferably 50 to 60% by mass. The higher the proportion of the polyphenylene ether skeleton, the higher the effect of preventing an increase in dielectric constant of a resin composition. For this reason, the skeleton portion is preferably 30% by mass or more, more preferably 40% by mass or more, and further preferably 50% by mass or more. When the proportion of the polyphenylene ether skeleton is 90% by mass or less, a characteristic feature of a resin composition according to the present invention, that is, the solubility of the resin in a ketone at room temperature, is successfully expressed. The proportion of the polyphenylene ether skeleton is preferably 80% by mass or less, and further preferably 60% by mass or less.

The epoxylated polyphenylene ether resin of the present invention preferably has a number average molecular weight of 3,200 to 10,000, more preferably 3,500 to 8,500, and further preferably 5,000 to 7,000. When the number average molecular weight is 10,000 or less, the melt viscosity of the resin is low, exhibiting good processability. The number average molecular weight is more preferably 8,500 or less, and further preferably 7,000 or less. When the number average molecular weight is 3,200 or more, a resin having good electric properties can be obtained. The number average molecular weight is more preferably 3,500 or more, and further preferably 5,000 or more. Assuming that the skeleton proportion of the polyphenylene ether is contained in the same proportion in the epoxylated polyphenylene ether resins, the larger the number average molecular weight of the resin, the higher the electric properties thereof. To explain more specifically, when the skeleton portion of polyphenylene ether is contained in a proportion of 30% by mass, which is the lowest proportion that allows the resin to dissolve in a ketone solution, even a resin having a number average molecular weight of 3,200 shows good electric properties. However, more satisfactory electric properties can be obtained in the case of a resin having a number average molecular weight of 3,500, and further satisfactory electric properties can be obtained in the case of a resin having a number average molecular weight of 5,000.

An epoxylated polyphenylene ether resin can be obtained by reacting a polyphenylene ether with an epoxy compound, for example, by reacting a polyphenylene ether with epichlorohydrin in accordance with a known method. More specifically, it can be obtained by dissolving polyphenylene ether in epichlorohydrin having an amount of at least one fold, preferably, at least 5 folds as large as the phenolic hydroxyl group of the polyphenylene ether, followed by adding thereto an alkaline metal hydroxide such as NaOH or KOH. The amount of the alkaline hydroxide is 1 equivalent or more relative to that of a phenolic hydroxide. The reaction is performed at 50 to 100°C for 1 to 10 hours. The resultant composition is washed with water or filtered to remove a generated salt and unreacted epichlorohydrin is distilled off or adding a poor solvent such as methanol, thereby precipitating a desired resin.

The epoxylated polyphenylene ether resin can also be obtained by reacting a polyphenylene ether and an epoxy resin in the presence of a catalyst for catalyzing the reaction between a phenolic hydroxyl group and an epoxy group, at 100 to 200°C for 1 to 20 hours, followed by removing an unreacted epoxy resin. As the catalyst, use may be made of one or more compounds selected from the group consisting of hydroxides such as sodium hydroxide and potassium hydroxide; alkylate salts such as sodium methylate and sodium butylate; quaternary ammonium salts such as tetrabutylammonium chloride and tetramethyl ammonium bromide; phosphonium salts such as tetraphenyl phosphonium bromide, amyl triphenyl phosphonium bromide; imidazole compounds such as 2-methylimidazole and 2-methyl-4-imidazole; amines such as N,N-diethylethanol amine; and potassium chloride. As the epoxy resin to be used herein, any epoxy resin may be used as long as it contains not less than two epoxy groups within a molecule. Examples of such an epoxy resin include a bisphenol A-type epoxy resin, a bisphenol F-type epoxy resin, a bisphenol S-type epoxy resin, a hydantoin-type epoxy resin, a biphenyl type epoxy resin, an alicyclic type epoxy resin, a triphenyl methane type epoxy resin, a phenol-novorak type epoxy resin and a cresol-novorak type epoxy resin and halogenated products of these epoxy resins. Furthermore, mention may be made of diglycidyl ethers such as a polyethylene glycol, a polypropylene glycol, butane diol, hexane diol, and cyclohexane dimethanol. They may be used singly or in the form of a mixture of two types or more. Unreacted epoxy resin is removed by dissolving the reaction product in a solvent such as toluene, adding thereto an excessive amount of methanol to precipitate the epoxylated polyphenylene ether resin, which is collected by filtration.

An epoxylated polyphenylene ether resin according to the present invention having, in average, not less than 3 epoxy groups per molecule can be obtained by directly adding at least 5% by mass, preferably at least 10% by mass, and more preferably at least 20% by mass of a multifunctional epoxy resin itself to the epoxy resin. As the content of the multifunctional epoxy resin increases, the average number of epoxy groups contained in the resultant epoxylated polyphenylene ether resin increases. In reacting a polyphenylene ether with an epoxy resin, it is preferable that two types or more of epoxy resins are used. In particular, one or more types of multifunctional epoxy resins and one or more

types of bifunctional epoxy resins are preferably used. The multifunctional epoxy resin is useful in increasing the number of epoxy groups in the resultant epoxylated polyphenylene ether resin; however, the presence of the multifunctional epoxy resin makes a polyphenylene ether difficult to dissolve in a reaction system and causes gelation by the reaction with the polyphenylene ether. Therefore, a solvent must be added to the reaction system. However, if a bifunctional epoxy resin is added to the reaction system, it dissolves polyphenylene ether, rendering the reaction to easily take place, while preventing gelation. Thus, the reaction proceeds even in the system containing no solvent to obtain a desired epoxylated polyphenylene ether resin.

The terminal phenolic hydroxyl group of an epoxylated polyphenylene ether resin is preferably 10 meq/kg or less. If the terminal phenolic hydroxyl group is 10 meq/kg or less, the resin can be dissolved in a ketone stably for a long time. To attain a stable long-term solubility in a ketone, the terminal phenolic hydroxyl group is preferably 5 meq/kg or less and further preferably 3 meq/kg or less.

The phrase "dissolving in a ketone at room temperature" means herein that a ketone solution having a resin in an amount of 10% by mass is transparent at room temperature. More specifically, when the solution is filtrated, preferably, the filtration residue is not obtained. The state of the solution having substantially no solid matter must be maintained not only right after the solution is made but also for one or more days, preferably 30 days or more, and further preferably, 90 days or more. This is because it usually takes time from preparation of an epoxy resin composition solution until use.

Examples of a ketone to be used in the present invention include aliphatic ketones such as acetone, methylethyl ketone, methylisopropyl ketone, methylisobutyl ketone, and cyclohexanone; and aromatic ketones such as acetophenone. Preferably acetone and methylethylketone and more preferably methylethyl ketone is used. That is because, depending upon the structure of the polyphenylene ether to be dissolved, methylethyl ketone can maintain the state-of-no-solid matter and requires less modification of a conventional process since methylethyl ketone is usually used in a varnish for forming a laminate board.

The ketone solution of the present invention is not particularly limited in mass as long as it contains a ketone; however, the content of ketone is satisfactorily 5% by mass or more, preferably 15% by mass or more, more preferably 30% by mass or more, and further preferably 50% by mass or more. Because an epoxylated polyphenylene ether resin is not easily dissolved in a solvent other than a ketone and a halogen solvent, if the content of a ketone is low, problems such as crystallization and precipitation take place.

To impart other properties besides electric properties to an epoxylated polyphenylene ether resin according to the present invention, the resin may be mixed with an epoxy resin and used in the form of an epoxy resin composition. In such a case, the content of the epoxylated polyphenylene ether resin is preferably 25% by mass or more of the epoxy resin composition. When the content is less than 25% by mass, the ratio of polyphenylene ether is low, lowering the electric properties.

When the epoxy resin to be mixed is an epoxy resin having an oxazolidone ring, the cured product obtained can be improved in adhesion properties to a copper foil and a plastic without reducing the heat resistance thereof. To impart flame resistance to the cured product, at least one type of a brominated epoxy resin, a phosphazene compound containing an epoxy group, a phosphate ester, a condensed phosphate ester, and a quinoline derivative of a phosphine compound may be contained as a flame retardant. The flame resistance can be attained if the flame retardant is contained in an amount of 10% by mass or more of the total epoxy resin composition. In this case, if the combination of a flame retardant(s) selected does not contain a brominated epoxy resin, a halogen-free flame-retardant resin can be obtained.

As the mixing ratio of the components in an epoxy resin composition, it is preferable that an epoxylated polyphenylene ether resin is from 40 to 90% by mass; a flame retardant is from 10 to 50% by mass; an epoxy resin (preferably one having an oxazolidone ring) is from 0.1 to 30% by mass. More preferably, an epoxylated polyphenylene ether resin having a polyphenylene ether as the skeleton portion in a ratio of 50 to 60% by mass is 50 to 60% by mass, a flame retardant is 20 to 25% by mass, and an epoxy resin having an oxazolidone ring is 1 to 10% by mass. If the components are mixed in the aforementioned ratio, the resin composition is obtained with good electrical properties and well balanced heat resistance, adhesiveness and processability while maintaining flame resistance.

Next, the cage-form silsesquioxane to be used in the present invention and its partially cleaved structure will be explained.

Although silica is the compound represented by $SiO_2$, silsesquioxane is a compound represented by $[R'SiO_{3/2}]_n$. Silsesquioxane is a polysiloxane synthesized by hydrolysis/polycondensation of a compound represented by $R'SiX_3$ (R' is hydrogen atom, a hydrocarbon group, or a silicon atom-containing group; and X is a halogen atom or an alkoxy group). The molecules are typically arranged in an amorphous structure, a ladder-form structure, a cage-form structure (i.e., a complete condensation cage-form structure) or a partially cleaved structure thereof (i.e., a cage-form structure from which a silicon atom has been removed or a cage-form structure in which a part of silicon-oxygen bonds is cleaved).

Specific structural examples of the cage-form silsesquioxane to be used in the present invention may include a cage-form silsesquioxane represented by the following general formula (A). Furthermore, specific structural examples of the partially cleaved structure of the cage-form silsesquioxane to be used in the present invention may include one

represented by the following general formula (B). However, structural examples of the cage-form silsesquioxane and the partially cleaved structure thereof are not limited to these examples.

$$[RSiO_{3/2}]_n \quad (A)$$

$$(R'SiO_{3/2})_l(RXSiO)_k \quad (B)$$

In the general formulas (A) and (B), R is selected from the group consisting of hydrogen atom, an alkoxyl group or aryloxy group having 1 to 6 carbon atoms, a substituted or unsubstituted hydrocarbon group having 1 to 20 carbon atoms, and a silicon atom-containing group having 1 to 10 silicon atoms. R may be constituted of the same groups and a plurality of groups.

Examples of the cage-form silsesquioxane represented by the general formula (A) used in the present invention include types represented by the chemical formula $[RSiO_{3/2}]_6$ (the following general formula (2)), the chemical formula $[RSiO_{3/2}]_8$ (the following general formula (3)), the chemical formula $[RSiO_{3/2}]_{10}$ (the following general formula (4)), the chemical formula $[RSiO_{3/2}]_{12}$ (the following general following formula (5)), and the chemical formula $[RSiO_{3/2}]_{14}$ (the following general formula (6)).

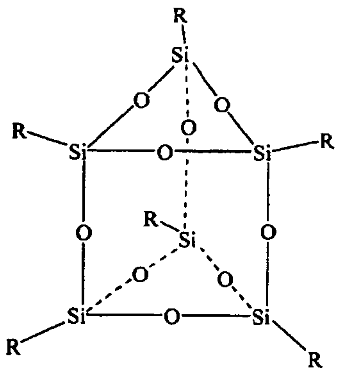

(2)

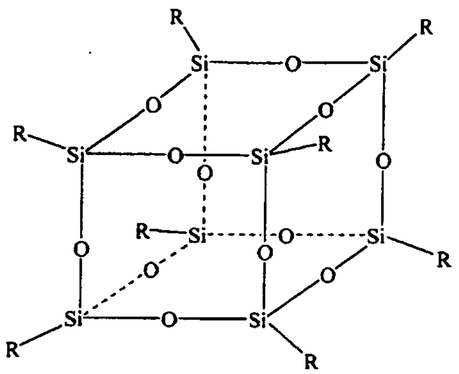

(3)

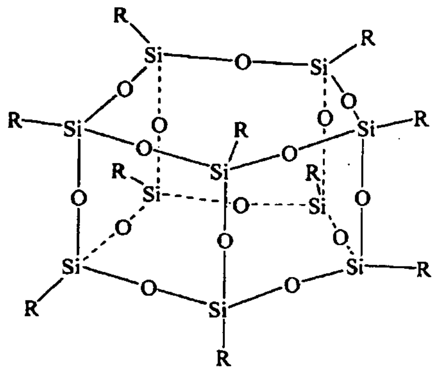

(4)

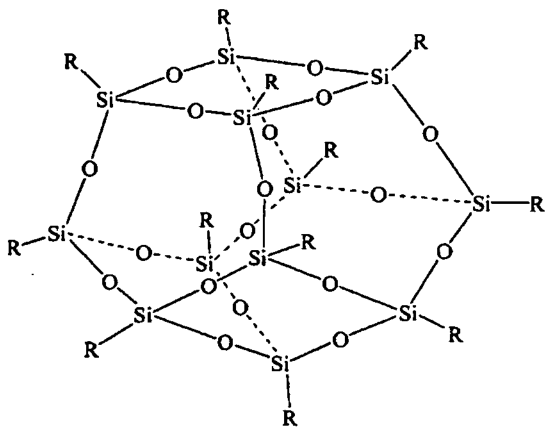

(5)

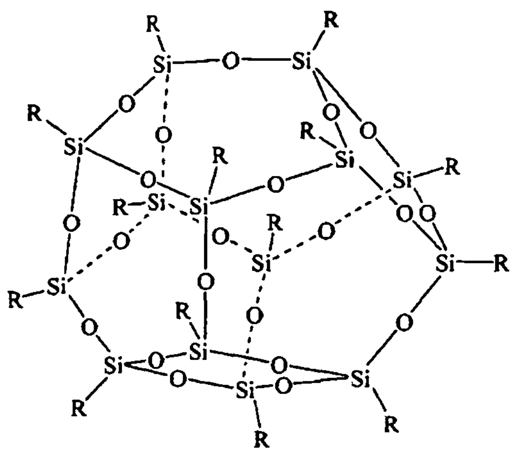

(6)

In a cage-form silsesquioxane represented by the general formula (A) $[RSiO_{3/2}]_n$, n is an integer of 6 to 14, preferably 8, 10 or 12, and more preferably 8, 10 or 8 and 10 in combination, or 8, 10 and 12 in combination, particularly preferably 8 or 10.

Further in the present invention, use may be made of a partially cleaved structure of a cage-form silsesquioxane where a part of silicon-oxygen bonds is cleaved, or a structure of a cage-form silsesquioxane having a partial structural deficiency, alternatively, a partially cleaved structure of a cage-form silsesquioxane derived therefrom and represented by the general formula (B) $[RSiO_{3/2}]_l(RXSiO)_k$ (1 is an integer from 2 to 12, and k is 2 or 3).

In the general formula (B), X is a group selected from the group consisting of a group represented by $OR_1$ ($R_1$ is hydrogen atom, an alkyl group, or a quaternary ammonium radical), a halogen atom, and groups defined as R above). A plurality of Xs may be the same or different. In the formula, 1 is an integer of 2 to 12, preferably 4 to 10, and particularly preferably 4, 6 or 8; k is 2 or 3. Two or three Xs in the same molecule represented by the formula $(RXSiO)_k$ may be connected to each other to form various types of coupled structures. Specific examples of the coupled structures will be explained below.

Two Xs in the same molecule represented by the general formula (B) may form an intermolecular coupled structure represented by the general formula (7). Furthermore, two Xs present in different molecules are coupled with each other to form a coupled structure represented by the general formula (7), thereby forming a binuclear structure.

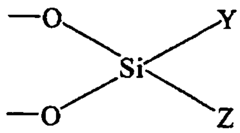

(7)

where Y and Z are selected from the same groups as X, and Y and Z may be the same or different.

Examples of a coupled structure represented by the general formula (7) include a structure of a bivalent group represented by the following formulas (8) to (14), where Ph represents a phenyl group.

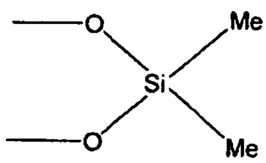

(8)

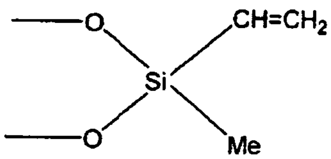

(9)

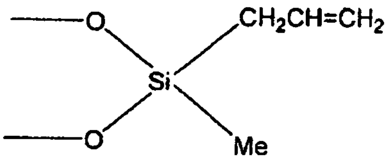

(10)

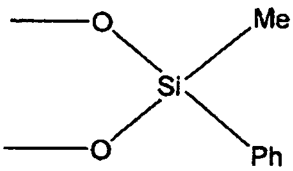

(11)

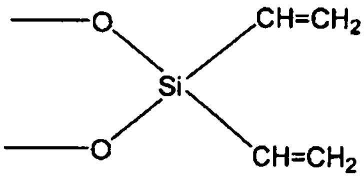

(12)

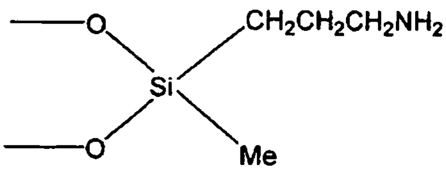

(13)

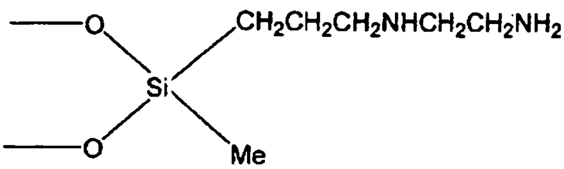

(14)

Examples of compounds represented by the general formula (B) to be used in the present invention include a trisilanol type represented by the general formula (3) which has a partial structural deficiency, a type of compound

synthesized therefrom and represented by a chemical formula $(RSiO_{3/2})_4$ $(RXSiO)_3$ (e.g., the following general formula (15)), a type of compound having a coupled structure represented by the general formula (15) or the chemical formula $(RSiO_{3/2})_4$ $(RXSiO)_3$ in which two of three Xs form a coupled structure represented by the general formula (7) (for example, the following general formula (16)), a type of compound derived from a disilanol structure, which has a partially cleaved structure of the general formula (3) and represented by the chemical formula $(RSiO_{3/2})_6$ $(RXSiO)_2$ (for example, the following general formulas (17) and (18)), and a type of compound represented by the general formula (17) or the chemical formula $(RSi0_{3/2})_6$ $(RXSiO)_2$ in which two Xs form a coupled structure represented by the general formula (7) (for example, the general formula (19)). In the general formulas (15) to (19), R and X or Y and Z bonding to the same silicon atom may be mutually exchanged in position. Furthermore, two Xs present in different molecules are mutually coupled via any one of various coupled structures represented by the general formula (7) to form a binuclear structure.

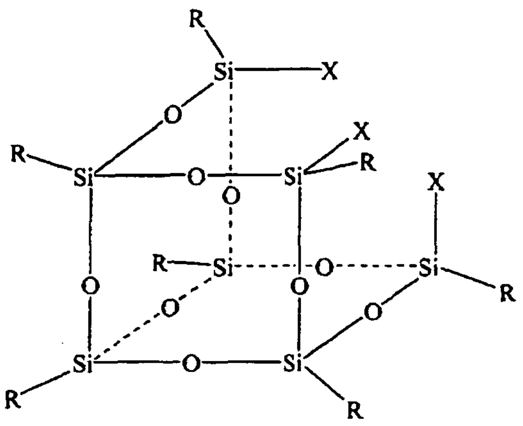

(15)

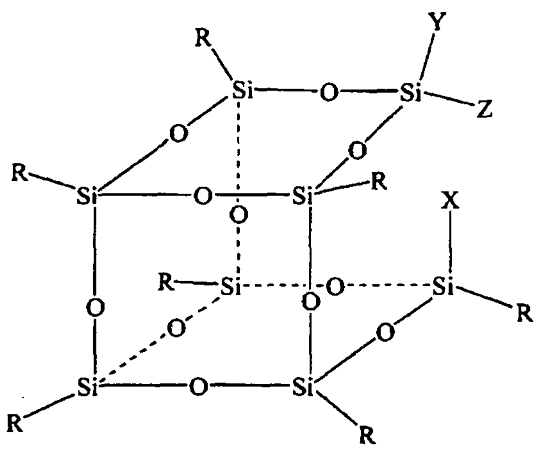

(16)

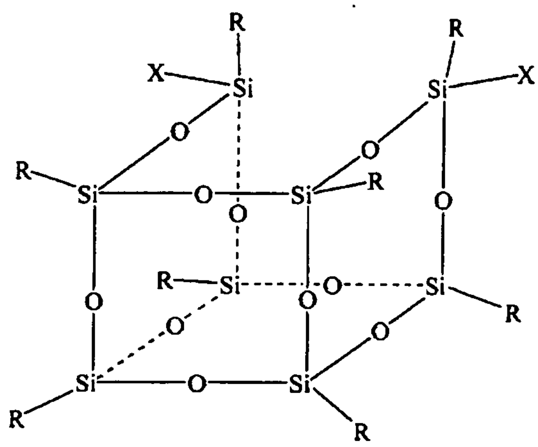

(17)

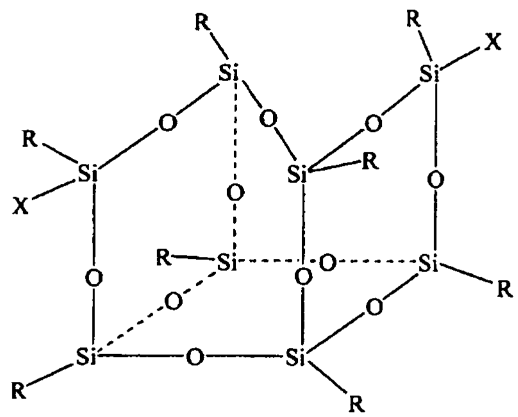

(18)

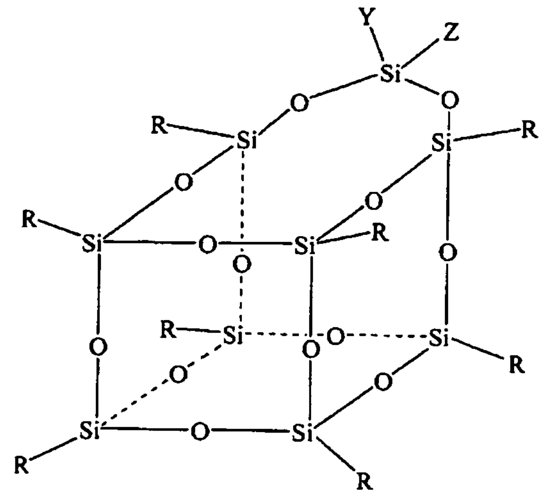

(19)

Examples of a compound having a couple structure containing a metal atom other than a silicon atom by coupling two or three Xs of the general formula (B) include a compound represented by the chemical formula $(RSiO_{3/2})_4$ $(RXSiO)_3$ , which is a compound represented by the general formula (8) in which three Xs forms a coupled structure containing a Ti atom.

These various cage-form silsesquioxane compounds or partially cleaved compounds thereof may be used singly or in the form of a mixture of a plurality of compounds.

Examples of R in a compound represented by the general formula (A) and/or the general formula (B) and to be used in the present invention may include hydrogen atom, an alkoxy group and an aryloxy group, a substituted or unsubstituted hydrocarbon group having 1 to 20 carbon atoms, and a silicon atom-containing group having 1 to 10 silicon atoms.

Examples of the alkoxyl group having 1 to 6 carbon atoms include methoxy group, ethoxy group, n-propyloxy group, i-propyloxy group, n-butyloxy group, t-butyloxy group, n-hexyloxy group, and cyclohexyloxy group. Examples of the aryloxy group include phenoxy group and 2, 6-dimethylphenoxy group. The number of alkoxyl groups and aryloxy groups within a molecule of a compound represented by the general formula (A) or (B) is preferably 3 or less and more preferably 1 or less in total.

Examples of the hydrocarbon group having 1 to 20 carbon atoms include noncyclic or cyclic aliphatic hydrocarbon groups such as methyl, ethyl, n-propyl, i-propyl, butyl (n-butyl, i-butyl, t-butyl, sec-butyl), pentyl (n-pentyl, i-pentyl, neopentyl, cyclopentyl, etc.), hexyl (n-hexyl, i-hexyl, cyclohexyl, etc.), heptyl (n-heptyl, i-heptyl, etc.), octyl (n-octyl, i-octyl, t-octyl, etc.), nonyl (n-nonyl, i-nonyl etc.), decyl (n-decyl, i-decyl etc.), undecyl (n-undecyl, i-undecyl etc.), dodecyl (n-dodecyl, i-dodecyl etc.); noncyclic or cyclic alkenyl groups such as vinyl, propenyl, butenyl, pentenyl, hexenyl, cyclohexenyl, cyclohexenylethyl, norbonenylethyl, heptenyl, octenyl, nonenyl, decenyl, undenyl, dodecenyl, and styrenyl; aralkyl groups such as benzyl, phenethyl, 2-methylbenzyl, 3-methylbenzyl, and 4-methylbenzyl etc.; aralkenyl groups such as phCH=CH group; aryl groups such as phenyl group, tolyl group and xylyl group; and substituted aryl groups such as a 4-aminophenyl group, 4-hydroxyphenyl group, 4-methoxyphenyl group, and 4-vinylphenyl group.

In the case where the number of aliphatic hydrocarbon group having 2 to 20 carbon atoms and the number of alkenyl group having 2 to 20 carbon atoms of these hydrocarbon groups, are larger in proportion than the total numbers of R, X, Y and Z, specially excellent melt fluidity can be obtained in forming a cured product. Furthermore, in the case where R is an aliphatic hydrocarbon group and/or an alkenyl group, the number of carbon atoms is typically 20 or less, preferably 16 or less, and more preferably, 12 or less, in view of the balance of the melt fluidity in forming a cured product, flame resistance and operability.

Examples of R to be used in the present invention may include the above-cited hydrocarbon groups in which a part of hydrogen atoms or a main skeleton may be substituted by a substituent selected from the group consisting of polar groups (polar bondings) such as an ether bond, an ester group (bond), hydroxyl group, carbonyl group, a carboxylic acid anhydride bond, thiol group, thioether group, sulfone group, aldehyde group, epoxy group, amino group, amide

group (bond), urea group (bond), isocyanate group, and cyano group; and halogen atoms such as fluorine atom, chlorine atom, and bromine atom.

Low melt viscosity of the epoxy resin composition is closely related to improving moldability of an epoxy resin curable composition containing the following curing agent. When a substrate is impregnated with an epoxy resin curable composition and dried, an epoxy group reacts with a curing agent or an epoxy group reacts with a part of phenolic hydroxyl group, coming to the state of the B-stage. When the epoxy resin curable composition in the state of the B-stage is then heated under pressure, the viscosity of the molten resin once decreases to the lowest level in the system and then increases with the proceeding of curing. The melt viscosity of the epoxy resin composition has an effect on the lowest viscosity. That is because the lower the melt viscosity of an epoxy resin composition, the lower the lowest viscosity.

The present inventors have surprisingly found that the melt viscosity of an epoxy resin composition according to the present invention can be remarkably decreased by adding a cage-form silsesquioxane and/or a partially cleaved structure of cage-form silsesquioxane thereto. Moreover, they have found that the addition of a cage-form silsesquioxane and/or a partially cleaved structure of cage-form silsesquioxane also improves flame resistance.

The content of cage-form silsesquioxane and/or cage-form silsesquioxane in an epoxy resin composition is preferably 0.1% to 50% by mass, more preferably 0.5% to 30% by mass, and further preferably 1% to 10% by mass. When the content is 0.1% or more, the melt viscosity and the flame resistance of the resin composition is effectively improved.

Any epoxy resin curing-agent may be used as long as it can react with an epoxy resin to form a three dimensional network structure. As examples of such an epoxy resin curing-agent, mention may be made of a non-latent curing agent and latent curing agents which include amide-based curing agents such as dicyandiamide and an aliphatic polyamide; amine-based curing agents such as diaminodiphenyl methane, methaphenylene diamine, ammonia, triethyl amine, and diethyl amine; phenol-based curing agents such as bisphenol A, bisphenol F, phenol novorak resin, cresol novorak resin, and p-xylene novorak resin; and acid anhydride-based curing agents. They may be used singly or in the form of a mixture of two or more types.

To accelerate a curing reaction of an epoxy resin composition, it is practical to add an accelerator other than a curing agent. Examples of such an accelerator include imidazoles such as 2-methylimidazole, 2-methyl-4-ethylimidazole, and 2-phenylimidazole; tertiary amines such as 1,8-diazabicyclo[5.4.0]-undecene-7, triethylenediamine, and benzyldimethylamine; organic phosphines such as tributyl phosphine and triphenyl phosphine; and tetraphenylboron salts such as tetraphenylphosphonium tetraphenylborate and triphenylphosphine tetraphenylborate. They may be used singly or in the form of a mixture of two or more types.

In the present invention, the term "substantial phase separation takes place" means that, when the cured product obtained is measured by a light diffusion measuring apparatus, there is a diffusion maximum in the range of 0.1 μm to 100 μm. The phase separation also can be confirmed under optical microscopic observation. Because no substantial phase separation takes place in a cured product of an epoxylated polyphenylene ether resin according to the present invention, a distinctive diffusion maximum is not observed by the phase separation observation. Also, a distinctive phase separation of a cured product is not observed by optical microscopic observation.

To prepare a varnish containing an epoxy resin composition according to the present invention, use many be made of not only a known solvent, which is used in preparing a varnish of an epoxy resin composition containing a polyphenylene ether, including a halogen solvent such as dichloromethane or chloroform and an aromatic solvent such as benzene, toluene, or xylene, but also a ketone-based solvent. Examples of such a ketone-based solvent include aliphatic ketones such as acetone, methylethyl ketone, methylisopropyl ketone, methylisobutyl ketone and cyclohexanone, and aromatic ketones such as acetophenone.

Usually, a varnish of an epoxy resin composition containing polyphenylene ether employs toluene as a solvent and must be kept at a temperature of e.g., 50°C or more at which the varnish can be stabilized. However, in the case of an epoxy resin-based varnish using a ketone as a solvent, since it can be kept at room temperature, it can be treated in the same manner as the case of a general one. Such a composition is preferable since no specific handling and apparatus are required unlike a general varnish of an epoxy resin composition containing a polyphenylene ether.

When a curing agent such as dicyandiamide and an accelerator hard-to-dissolve in a ketone , are used, in addition to a ketone as a main solvent, an auxiliary solvent such as dimethyl formamide, methyl cellosolve, propylene glycol monomethyl ether, or mesitylene may be used. In the meantime, although the concentration of solid matter in a varnish is not particularly limited, it preferably falls in the range of 30% to 80%.

A prepreg according to the present invention is manufactured by impregnating a substrate with the aforementioned varnish, volatizing a solvent, applying heat to perform semi-curing. Examples of the substrate include glass cloth, aramide cloth, polyester cloth, nonwoven glass cloth, nonwoven aramide cloth, nonwoven polyester cloth, pulp paper, and linter pulp etc. Although the amount of resin impregnating the substrate is not particularly limited, it is suitably controlled in such a manner that the content of the resin after drying falls within the range of 30 to 70% relative to the mass of the prepreg.

A curable resin/metal foil composite according to the present invention is constituted of a film formed of an

epoxy resin curable composition and a metal foil. Although thickness of the film is not particularly limited, it typically falls within the range of 0.5 μm to 5 mm. The metal foil used herein is preferred to be electrically conductive. For example, copper foil or aluminium foil may be used.

Examples of a method of manufacturing a metal foil with a curable resin applied thereon include a method of dissolving an epoxy resin curable composition in a solvent and casting the solution on the metal foil; a method of adhering a metal foil on a film previously formed of an epoxy resin curable composition with heating under pressure; and a method of laminating a metal layer of copper or aluminium on a film formed of an epoxy resin curable composition by sputtering, depositing, or plating.

The film formed of an epoxy resin curable composition according to the present invention is manufactured by preparing a solution of the composition, applying the solution onto a polyethylene terephthalate film by a bar coater or the like, and removing the solvent by drying. The film thus prepared into the state of the B stage is laminated on a both sides of a copper clad foil plate by means of hot rolling or the like and subjected to heat treatment in an oven to form a multi-layered product.

A laminate plate according to the present invention can be manufactured by laminating a prepreg, a curable resin/metal foil composite, a film and copper foil in accordance with a layer structure suitable for intended use, followed by applying heating pressure on the laminate. More specifically, a plurality of prepregs and curable resin/metal foil composites are mutually laminated on a substrate and individual layers of the laminate are adhered to each other and simultaneously crosslinked with heating under pressure to obtain a laminate board having a desired thickness. Alternatively, a plurality of curable resin/metal foil composites are laminated on a substrate and individual layers are adhered with each other and simultaneously cured with heating under pressure to form a laminate board of a desired thickness. The metal foil may be used as a surface layer or an intermediate layer. Alternatively, the laminate process and the curing process are repeated multiple times to gradually obtain a laminate.

A multilayer printed wiring board formed of an epoxylated polyphenylene ether resin according to the present invention has at least one conductive layer serving as a circuit board and at least one organic insulating layer mutually laminated. Such a wiring board may be manufactured by a build-up system using plating, a build-up system using conductive paste adhesion, or an integrated lamination method using a copper clad laminate board and a resin composition for an adhesive agent. However, a manufacturing method for a wiring board is not limited to these. In this case, when the film and the laminate board are used, a multilayer printed wiring board can be obtained with quite excellent electric properties, adhesion properties, heat resistance and solvent resistance.

The electronic apparatus of the present invention employs the multilayered printed wiring board. Examples of such an electronic apparatus include, but are not limited to, a communication router, a computer, a television, a portable phone, a PDA, a DVD recorder, a hard disk recorder, and a digital camera.

A sealing resin composition according to the present invention is not particularly limited as long as it contains an epoxy resin composition according to the present invention, and may appropriately contain an inorganic filler, a releasing agent, a coloring agent, a flame retardant, and a stress-reducing agent. The inorganic filler may be subjected to a surface treatment by a coupling agent in order to smoothly adapt itself to an epoxy resin composition. Examples of the releasing agent include carnauba wax and a polyolefin containing a carboxyl group. As the coloring agent, for example, carbon black may be mentioned. As the flame retardant, for example, antimony trioxide may be mentioned. As the stress-reducing agent, for example, silicon rubber and silicon oil may be mentioned. A sealing resin composition prepared by using an epoxy resin composition according to the present invention is very excellent in processability, heat resistance and moisture absorption properties.

An epoxy resin composition according to the present invention may be used as an adhesive agent. Application of the adhesive agent may not be particularly limited. However, the adhesive agent, if it is applied to electrical use, sufficiently exerts its excellent effects including electrical properties, adhesive properties, heat resistance and processability.

(Examples and Comparative Examples)

The embodiments of the present invention will be more specifically explained with reference to Examples and Comparative Examples, below.

Each of the properties was evaluated in accordance with the following method.

(1) Melt viscosity

The melt viscosity (unit: mPa·s) of an epoxy resin composition at 180°C was measured by rheomat-30 manufactured by Contraves Inc.

(2) Molecular weight

Gel permeation chromatographic analysis was performed using Shodex A-804, A-803, A-802 and A802 manufactured by Showa Denko K.K. as a column. The molecular weight was determined based on an elution time in comparison with that of a polystyrene known in molecular weight.

(3) Amount of phenolic hydroxyl group

Polyphenylene ether was dissolved in methylene chloride, and then a methanol solution of 0.1 N tetraethyl ammonium hydroxide was added thereto. After vigorously stirred, absorbance was measured at 318 nm. The amount (unit: meq/kg) of phenolic hydroxyl group was determined based on the difference in absorbance with a case where the methanol solution of 0.1 N tetraethyl ammonium hydroxide was not added thereto.

(4) Epoxy equivalent

Epoxy equivalent was measured in accordance with JIS K 7236.

(5) Bending strength

Bending strength was measured by a material testing machine Type 5582 manufactured by Instron Corporation based on JIS C 6481.

(6) Dielectric constant and dielectric tangent of laminate board

Dielectric constant and dielectric tangent were measured by LCR meter 4284A manufactured by Agilent Technologies Inc. based on JIS C 6481.

(7) Measurement of insoluble matters in solvent

A resin was dissolved in a solvent with heating. After the resin solution was returned to room temperature, it was filtrated by a membrane filter. The filter was heated to volatilize the solvent. Insoluble matters (% by mass) were measured based on the difference in mass of the filter before and after the volatilization of the solvent.

(8) Measurement of phase separation

A varnish was cured to obtain a cured product, which was checked for the presence or absence of a diffusion maximum (that is, the presence or absence of phase separation) in the range of 0.1 μm to 100 μm by a light diffusion measuring apparatus DYNA-3000 (manufactured by Otsuka Electronics Co., Ltd.). The surface of the cured product was observed by use of a laser microscope VHX-100 (manufactured by KEYENCE Corp.). The case where phase separation was observed was evaluated by ×, whereas the case where no phase separation was observed was evaluated by ○.

(9) Solvent resistance

A copper foil laminate board was soaked in methylene chloride at 35°C for 5 minutes and then appearance change was observed. The case where a blister was observed in the laminate board was evaluated by ×, where no blister was observed in the laminate board was evaluated by ○.

(10) Flammability test

Flammability was measured based on JIS C 6481.

(11) Number of epoxy groups

The number of epoxy groups of an epoxylated polyphenylene ether resin was calculated by dividing the molecular weight of the epoxylated polyphenylene ether resin by the epoxy equivalent.

(12) Measurement of Tg

Tg was measured based on the DSC method of JIS C 6481.

(13) Copper foil peel strength

Copper foil peel strength was measured by JIS C 6481.

[Preparation Example 1 of polyphenylene ether]

First, 10 parts by mass of a high-molecular weight polyphenylene ether having a number average molecular weight as large as 20,000 (manufactured by Asahi Kasei Corporation) and 30 parts by mass of bisphenol A were dissolved in 100 parts by mass of toluene with heating. To the solution mixture, 30 parts by mass of benzoyl peroxide was added and stirred at 90°C for 60 minutes, thereby performing a redistribution reaction. Furthermore, 10 parts by mass of benzoyl peroxide was added and stirred at 90°C for 30 minutes to complete the redistribution reaction. The reaction mixture was added to 1,000 parts by mass of methanol and the obtained precipitate was filtered off. The filtered material was further washed with 1,000 parts by mass of methanol to obtain polyphenylene ether I.

Polyphenylene ether I was analyzed by the gel permeation chromatography for molecular weight. As a result, the polyphenylene ether I had a number average molecular weight of 1,900 and did not contain the components of a molecular weight of 20,000 or more or 300 or less. Furthermore, the number of phenolic hydroxyl groups per molecule was 1.7.

[Preparation Example 2 of polyphenylene ether]

Polyphenylene ether II was obtained in the same manner as in Preparation Example 1 of polyphenylene ether except that the later washing step with methanol was not performed.

The polyphenylene ether II was analyzed by the gel permeation chromatography for molecular weight. As a result, the polyphenylene ether II had a number average molecular weight of 2,000 and did not contain components having a molecular weight of 20,000 or more but contained components of 300 or less. The number of phenolic hydroxyl groups per molecule was 1.7.

[Preparation Example 3 of polyphenylene ether]

A known method for preparing polyphenylene ether, e.g., a method disclosed in Examples of U.S. patent No. 6,211,327 was conducted, but the reaction was terminated in the early stage and washed with methanol. More specifically, 2,6-dimethyl phenol was reacted only for 30 minutes (although the reaction is generally conducted 100 minutes) in a solvent of toluene at a temperature ranging from 40 to 45°C while supplying oxygen and stirring in the presence of copper bromide and di-n-butylamine as a catalyst. Subsequently, the oxygen supply was stopped. While an aqueous nitrilotriacetic acid solution was added with stirring under nitrogen sealing to extract the copper catalyst into the water phase, the temperature of the reaction mixture was raised to 55°C and maintained at this state for 70 minutes. Thereafter, the copper catalyst was centrifugally removed, and the reaction solution was washed with a methanol solution. As a result, polyphenylene ether III having a number average molecular weight of 2,000 and containing no components of a molecular weight of 20,000 or more and 300 or less. The number of phenolic hydroxyl groups per molecule of the polyphenylene ether was 1.0.

[Preparation Example 4 of polyphenylene ether]

Polyphenylene ether IV was obtained in the same manner as in Preparation Example 1 of polyphenylene ether except that the step of adding additional benzoyl peroxide was not conducted.

Polyphenylene ether IV was analyzed by the gel permeation chromatography for molecular weight. As a result, the polyphenylene ether IV had a number molecular weight average of 2,300 and contained no components of 300 or less but contained components of 20,000 or more. The number of phenolic hydroxyl groups per molecule was 1.6.

[Preparation Example 5 of polyphenylene ether]

10 parts by mass of a high-molecular weight polyphenylene ether having a number average molecular weight as large as 20,000 (manufactured by Asahi Kasei Corporation) and 6 parts by mass of bisphenol A were dissolved in 100 parts by mass of toluene with heating. To the solution mixture, 30 parts by mass of benzoyl peroxide was added

and stirred at 90°C for 60 minutes to conduct a redistribution reaction. Furthermore, the reaction mixture was added to 1,000 parts by mass of methanol and the obtained precipitate was filtered off. The filtered product was further washed with 1,000 parts by mass of methanol to obtain polyphenylene ether V.

Polyphenylene ether V was analyzed by the gel permeation chromatography for molecular weight. As a result, the polyphenylene ether V had a number average molecular weight of 4,500 and contained no components of 300 or less but contained components of a molecular weight of 20,000 or more. The number of phenolic hydroxyl groups per molecule was 1.6.

[Preparation Example 6 of polyphenylene ether]

The reaction was conducted in the same manner as in Preparation Example 3 except that 2,6-dimethylphenol containing 2,2-bis(3,5-dimethyl-4-hydroxyphenyl) propane was used. As a result, polyphenylene ether VI was obtained having a number average molecular weight of 2,700 and containing 0.5% by mass of components having a molecular weight of 20,000 or more but containing no components of a molecular weight of 300 or less. The number of phenolic hydroxyl groups per molecule of the polyphenylene ether was 1.8.

[Preparation Example 7 of polyphenylene ether]

10 parts by mass of a high-molecular weight polyphenylene ether having a number average molecular weight as large as 20,000 (manufactured by Asahi Kasei Corporation) and 30 parts by mass of bisphenol A were dissolved in 100 parts by mass of toluene with heating. To the solution mixture, 60 parts by mass of benzoyl peroxide was added and stirred at 90°C for 60 minutes to conduct a redistribution reaction. Furthermore, 60 parts by mass of benzoyl peroxide was added and stirred at 90°C for 30 minutes to complete the redistribution reaction. The reaction mixture was added to 1,000 parts by mass of methanol and the obtained precipitate was filtered off. The filtered product was further washed with 1,000 parts by mass of methanol to obtain polyphenylene ether VII.

Polyphenylene ether VII was analyzed by the gel permeation chromatography for molecular weight. As a result, the polyphenylene ether VII had a number average molecular weight of 1,100 and did not contain components of a molecular weight of 20,000 or more or 300 or less. The number of phenolic hydroxyl groups per molecule was 1.8.

[Manufacture Example of copper clad laminate board]

To an epoxy group of a composition serving as a curing agent, 0.6 fold equivalent of dicyandiamide as an amino group, methylethyl ketone as a solvent were added. The varnish was adjusted so as to contain 60% by mass of a solid matter. In Examples 1 to 3 (described later), it was designed that phenolic hydroxyl groups of polyphenylene ether completely react with epoxy groups, so that dicyandiamide was added in an amount so as to correspond to the number of epoxy groups from which the number of phenolic hydroxyl group was detracted.

Furthermore, 2-methylimidazol serving as a curing agent was added in an amount ranging from 0.1 to 0.3% by mass relative to the content of the solid matter of the varnish, in which the gelation time (time required for gelation) of the varnish at 170°C fell within the range of 4 to 5 minutes.

Subsequently, glass cloth (manufactured by Asahi-Scwebel Corporation, trade name: 2116) was impregnated with an epoxy resin varnish and dried to obtain a prepreg having a resin content of 50% by mass. Four sheets of the prepreg obtained above were laminated and a copper foil sheet of 35 μm thick was superposed to the upper and lower sides thereof. The resultant laminate was pressurized at a pressure of 20 $kg/cm^2$ with heating at a temperature of 190°C for 60 minutes to obtain a both sided copper clad laminate board.

The Tg of the obtained both sided copper clad laminate board was measured by DSC. The bending strength of the laminate board was evaluated by a bending test.

[Example 1]

An epoxy resin composition (1) composed of 100 parts by mass of polyphenylene ether I and 100 parts by mass of a bisphenol Type A epoxy resin (AER 260 manufactured by Asahi Kasei Corporation) as an epoxy resin was dissolved in 130 parts by mass of methylethyl ketone. As a result, a homogeneous solution containing no insoluble matter was obtained at room temperature. When the solution was stored at 25°C, the state of a transparent brown solution was maintained for 4 days and turbidity was observed at the 5th day. When the amount of the insoluble matter was measured, it was 0.5% by mass.

Furthermore, 100 parts by mass of polyphenylene ether I and 100 parts by mass of AER260 were mixed and melted. The melt viscosity of the mixture measured at 180°C was 2,500 mPa·s.

[Example 2]

An epoxy resin composition (2) composed of 100 parts by mass of polyphenylene ether II and 100 parts by mass of a bisphenol Type A epoxy resin (AER 260 manufactured by Asahi Kasei Corporation) as an epoxy resin was dissolved in 130 parts by mass of methylethyl ketone. As a result, a homogeneous solution containing no insoluble matter was obtained at room temperature. When the solution was stored at 25°C, the state of a transparent brown solution was maintained for 4 days and turbidity was observed at the 5th day. When the amount of the insoluble matter was measured, it was 0.5% by mass.

[Example 3]

An epoxy resin composition (3) composed of 100 parts by mass of polyphenylene ether III and 100 parts by mass of a bisphenol Type A epoxy resin (AER 260 manufactured by Asahi Kasei Corporation) as an epoxy resin was dissolved in 130 parts by mass of methylethyl ketone. As a result, a homogeneous solution containing no insoluble matter was obtained at room temperature. When the solution was stored at 25°C, the state of a transparent brown solution was maintained for 3 days and turbidity was observed at the 4th day. When the amount of the insoluble matter was measured, it was 0.8% by mass.

[Comparative Example 1]

An epoxy resin composition (4) composed of 100 parts by mass of polyphenylene ether IV and 100 parts by mass of a bisphenol Type A epoxy resin (AER 260 manufactured by Asahi Kasei Corporation) as an epoxy resin was dissolved in 130 parts by mass of methylethyl ketone. As a result, a homogeneous solution was not obtained at room temperature and turbidity was observed. When the amount of the insoluble matter was measured, it was 1.2% by mass.

[Comparative Example 2]

An epoxy resin composition (5) composed of 100 parts by mass of polyphenylene ether V and 100 parts by mass of a bisphenol Type A epoxy resin (AER 260 manufactured by Asahi Kasei Corporation) as an epoxy resin was dissolved in 130 parts by mass of methylethyl ketone. As a result, a homogeneous solution was not obtained at room temperature and turbidity was observed. When the amount of the insoluble matter was measured, it was 2.5% by mass.

[Example 4]

50 parts by mass of polyphenylene ether I and 50 parts by mass of a bisphenol Type A epoxy resin (AER 260 manufactured by Asahi Kasei Corporation) as an epoxy resin were heated to 130°C, thereby melting and mixing them. To the resultant mixture, one part by mass of a 1% by mass sodium methylate/methanol solution was added and stirred until homogenized. After 5 minutes, the temperature of the molten product was increased to 190°C and stirred for 2 hours to obtain an epoxy resin composition (6).

The epoxy resin composition (6) had an epoxy equivalent of 502 and a melt viscosity of 3,100 mPa·s at 180°C. The amount of terminal phenolic hydroxyl group was 4.5 meq/kg. The content of unreacted epoxy quantified by gel permeation chromatography was 33 parts by mass based on the charged amount of 100 parts by mass. Accordingly, the proportion of the epoxylated polyphenylene ether resin was 67 parts by mass. When the content of terminal phenolic hydroxyl group per kg of the epoxylated polyphenylene ether resin was calculated, it was 6.7 meq/kg.

When 60 parts by mass of the epoxy resin composition (6) was dissolved in 40 parts by mass of methylethyl ketone, a completely homogenous solution was obtained without insoluble matter. When this solution was stored at 25°C, no precipitate appeared for 30 days or more without insoluble matter. Similarly, a 60% by mass acetone solution of epoxy resin composition I stored at 25°C produced no precipitate for 30 days or more.

10 g of the epoxy resin composition (6) was dissolved in 100 g of toluene and methanol was excessively added thereto so as to precipitate epoxylated polyphenylene ether resin I. The obtained epoxylated polyphenylene ether resin I had a molecular weight of 2,900 and an epoxy equivalent of 2,260. Accordingly, the proportion of polyphenylene ether skeleton was 65% by mass and the number of epoxy group per molecule was 1.6.

When a copper clad laminate board was formed using the epoxy resin composition (6), it had a dielectric constant of 4.2 at 1 MHz, a dielectric tangent of 0.011, Tg by DSC of 165°C, and a copper foil peel strength of 0.88 kgf/cm. The cured product had phase separation. After a solvent resistance test, a blister of the copper clad laminate board was observed.

[Example 5]

50 parts by mass of polyphenylene ether I and 50 parts by mass of a tetrabromo bisphenol Type A epoxy resin (AER 8018 manufactured by Asahi Kasei Corporation) as an epoxy resin were heated to 130°C, thereby melting and mixing them. To the resultant mixture, one part by mass of a 1% by mass sodium methylate/methanol solution was added and stirred until homogenized. After 5 minutes, the temperature of the molten product was increased to 190°C and stirred for 2 hours to obtain an epoxy resin composition (7).

The epoxy resin composition (7) had an epoxy equivalent of 1,369 and a melt viscosity of 70,000 mPa·s at 180°C. The amount of terminal phenolic hydroxyl group was 6.3 meq/kg. The content of unreacted epoxy quantified by gel permeation chromatography was 14 parts by mass based on the charged amount of 100 parts by mass. Accordingly, the proportion of the epoxylated polyphenylene ether resin was 86 parts by mass. When the content of terminal phenolic hydroxyl group per kg of the epoxylated polyphenylene ether resin was calculated, it was 7.3 meq/kg.

When 60 parts by mass of the epoxy resin composition (7) was dissolved in 40 parts by mass of methylethyl ketone, a completely homogenous solution was obtained without insoluble matter. When this solution was stored at 25°C, no precipitate appeared for 30 days or more. Similarly, a 60% by mass acetone solution of the epoxy resin composition (7) stored at 25°C produced no precipitate for 30 days or more.

10 g of the epoxy resin composition (7) was dissolved in 100 g of toluene and methanol was excessively added thereto so as to precipitate epoxylated polyphenylene ether resin II. The obtained epoxylated polyphenylene ether resin II had a molecular weight of 3,550 and an epoxy equivalent of 2,260. Accordingly, the proportion of polyphenylene ether skeleton of the epoxylated polyphenylene ether resin was 53.5% by mass and the number of epoxy group per molecule was 1.7.

When a copper clad laminate board was formed by using the epoxy resin composition (7), it had a dielectric constant of 3.9 at 1 MHz, a dielectric tangent of 0.008, Tg by DSC of 163°C, and a copper foil peel strength of 0.78 kgf/cm. The cured product had phase separation. After a solvent resistance test, a blister of the copper clad laminate board was observed.

[Example 6]

100 parts by mass of polyphenylene ether I was dissolved in 120 parts by mass of epichlorohydrin. To the solution, 10 parts by mass of a 50% by mass aqueous sodium hydroxide solution was added at 60°C over 60 minutes, and thereafter stirred at 60°C for 60 minutes. To the reaction solution, 50 parts by mass of water was added, stirred, and allowed to stand still. After an aqueous phase was separated to remove a produced salt, epichlorohydrin was distilled off under a reduced pressure to obtain an epoxylated polyphenylene ether resin III.

The obtained epoxylated polyphenylene ether resin III had a molecular weight of 2,010 and an epoxy equivalent of 1,570. Accordingly, the proportion of polyphenylene ether skeleton of the epoxylated polyphenylene ether resin was 95% by mass and the number of epoxy group per molecule was 1.7.

100 parts by mass of epoxylated polyphenylene ether resin III and 90 parts by mass of a tetrabromo bisphenol Type A epoxy resin (AER 8018 manufactured by Asahi Kasei Epoxy Co., Ltd.) were heated to 180°C, thereby melting and mixing them to obtain an epoxy resin composition (8). The obtained epoxy resin composition (8) had an epoxy equivalent of 632, and a melt viscosity of 17,000 mPa·s at 180°C. The amount of terminal phenolic hydroxyl group was 0.1 meq/kg.

When 60 parts by mass of the epoxy resin composition (8) was dissolved in 40 parts by mass of methylethyl ketone, insoluble matter was observed. Then, the solution was heated to 50°C. As a result, the insoluble matter was dissolved to obtain a completely homogeneous solution. The solution did not produce any precipitate after it was stored at 25°C for 10 days. Turbidity was observed at the 11th day with 0.5% by mass of insoluble matter. Similarly, a 60% by mass acetone solution of the epoxy resin composition (8) was homogenous without any precipitate. Turbidity was observed at the 7th day with 0.7% by mass of insoluble matter.

When a copper clad laminate board was formed by using the epoxy resin composition (8), it had a dielectric constant of 4.0 at 1 MHz, a dielectric tangent of 0.009, Tg by DSC of 166°C, and a copper foil peel strength of 0.86 kgf/cm. The cured product had phase separation. After a solvent resistance test, a blister of the copper clad laminate board was observed.

[Example 7]

50 parts by mass of polyphenylene ether III and 50 parts by mass of a bisphenol Type A epoxy resin (AER 260 manufactured by Asahi Kasei Corporation) as an epoxy resin were heated to 130°C, thereby melting and mixing them. To the resultant mixture, one part by mass of a 1% by mass sodium methylate/methanol solution was added and stirred until homogenized. After 5 minutes, the temperature of the molten product was increased to 190°C and stirred for 2

hours to obtain an epoxy resin composition (9).

10 g of the epoxy resin composition (9) was dissolved in 100 g of toluene and methanol was added thereto in a greatly excessive amount so as to precipitate epoxylated polyphenylene ether resin IV. The obtained epoxylated polyphenylene ether resin IV had a molecular weight of 2,450 and an epoxy equivalent of 2,500. Accordingly, the proportion of polyphenylene ether skeleton of the epoxylated polyphenylene ether resin was 82% by mass and the number of epoxy group per molecule was 0.98.

The epoxy resin composition (9) had an epoxy equivalent of 461 and a melt viscosity of 1,600 mPa·s at 180°C. The amount of terminal phenolic hydroxyl group was 2.0 meq/kg. The content of unreacted epoxy quantified by gel permeation chromatography was 41 parts by mass based on the charged amount of 100 parts by mass. Accordingly, the proportion of the epoxylated polyphenylene ether resin IV was 59 parts by mass. When the content of terminal phenolic hydroxyl group per kg of the epoxylated polyphenylene ether resin IV was calculated, it was 3.4 meq/kg.

When 60 parts by mass of the epoxy resin composition (9) was dissolved in 40 parts by mass of methylethyl ketone, a completely homogenous solution was obtained without insoluble matter. When this solution was stored at 25°C, no precipitate appeared for 19 days. Turbidity was observed at the 20th day with 0.7% by mass of insoluble matter. Similarly, a 60% by mass acetone solution of the epoxy resin composition (9) was obtained homogeneously. Turbidity was observed at the 13th day with 1.3% by mass of insoluble matter.

When a copper clad laminate board was formed by using the epoxy resin composition (9), it had a dielectric constant of 4.3 at 1 MHz, a dielectric tangent of 0.010, Tg by DSC of 155°C, and a copper foil peel strength of 0.40 kgf/cm. The cured product had phase separation. After a solvent resistance test, a blister of the copper clad laminate board was observed.

[Example 8]

The same method as Example 4 was repeated except that the reaction time at 190°C was set at one hour to obtain an epoxy resin composition (10). The obtained epoxy resin composition (10) had an epoxy equivalent of 455, and a melt viscosity of 2,500 mPa·s at 180°C. The amount of terminal phenolic hydroxyl group was 20.9 meq/kg. The content of unreacted epoxy quantified by gel permeation chromatography was 40 parts by mass based on the charged amount of 100 parts by mass. Accordingly, the amount of terminal epoxylated polyphenylene ether resin was 60 parts by mass. When the content of terminal phenolic hydroxyl group per kg of epoxylated polyphenylene ether resin was calculated, it was 34.6 meq/kg.

When 60 parts by mass of the epoxy resin composition (10) was dissolved in 40 parts by mass of methylethyl ketone, a completely homogenous solution was obtained without insoluble matter. When this solution was stored at 25°C, the state of a transparent brown solution was maintained for 5 days and turbidity was observed at the 6th day. When the insoluble matter was measured, it was 0.3% by mass.

When a copper clad laminate board was formed by using the epoxy resin composition (10), it had a dielectric constant of 4.4 at 1 MHz, a dielectric tangent of 0.012, Tg by DSC of 163°C, and a copper foil peel strength of 0.85 kgf/cm. The cured product had phase separation. After a solvent resistance test, a blister of the copper clad laminate board was observed.

[Example 9]

30 g of a cresol novorak type epoxy resin (ECN 1299 manufactured by Asahi Kasei Epoxy Co., Ltd.) and 30 g of a bisphenol type A epoxy resin (A250 manufactured by Asahi Kasei Epoxy Co., Ltd.) were heated to 100°C and mixed with stirring. After sufficiently mixed, 0.005 g of $NaOCH_3$ was added to the solution mixture as a catalyst and stirred for about 15 minutes. After heating to 180°C, 40g of polyphenylene ether I was added to the solution mixture and heated as it was for 3 hours at 180°C to 190°C to obtain an epoxy resin composition (11).

The epoxy resin composition (11) had an epoxy equivalent of 384, and a melt viscosity of 57,000 mPa·s at 180°C. The terminal phenolic hydroxyl group was 0.6 meq/kg. The content of unreacted epoxy quantified by gel permeation chromatography was 32 parts by mass based on the charged amount of 100 parts by mass. Accordingly, the proportion of terminal epoxylated polyphenylene ether resin was 68 parts by mass. When the content of terminal phenolic hydroxyl group per kg of the epoxylated polyphenylene ether resin was calculated, it was 0.9 meq/kg.

When 60 parts by mass of the epoxy resin composition (11) was dissolved in 40 parts by mass of methylethyl ketone, a completely homogenous solution was obtained without insoluble matter. When this solution was stored at 25°C, no precipitate appeared for 90 days without insoluble matter. Similarly, a 60% by mass acetone solution of the epoxy resin composition (11) did not produce a precipitate for 30 or more days when stored at 25°C.

10 g of the epoxy resin composition (11) was dissolved in 100 g of toluene and methanol was added thereto in a greatly excessive amount so as to precipitate epoxylated polyphenylene ether resin V. The obtained epoxylated polyphenylene ether resin V had a molecular weight of 5,200 and an epoxy equivalent of 830. Accordingly, the proportion

of polyphenylene ether skeleton of the epoxylated polyphenylene ether resin was 52% by mass and the number of epoxy groups per molecule was 6.3.

When a copper clad laminate board was formed by using the epoxy resin composition (11), it had a dielectric constant of 3.9 at 1 MHz, a dielectric tangent of 0.006, Tg by DSC of 190°C, and a copper foil peel strength of 1.47 kgf/cm. The cured product had no phase separation. After a solvent resistance test, a blister of the copper clad laminate board was not observed.

[Comparative Example 3]

50 parts by mass of polyphenylene ether resin IV and 50 parts by mass of bisphenol Type A epoxy resin (AER 260 manufactured by Asahi Kasei Corporation) were heated to 130°C, thereby melting and mixing them. To the resultant mixture, one part by mass of a 1% by mass sodium methylate/methanol solution was added and stirred until homogenized. After 5 minutes, the temperature of the molten product was increased to 190°C and stirred for 2 hours to obtain an epoxy resin composition (12).

The epoxy resin composition (12) had an epoxy equivalent of 430 and a melt viscosity of 9,000 mPa·s at 180°C. The terminal phenolic hydroxyl group was 5.2 meq/kg. The content of unreacted epoxy quantified by gel permeation chromatography was 36 parts by mass based on the charged amount of 100 parts by mass. Accordingly, the proportion of the epoxylated polyphenylene ether resin was 64 parts by mass. When the content of terminal phenolic hydroxyl group per kg of the epoxylated polyphenylene ether resin was calculated, it was 8.1 meq/kg.

When 60 parts by mass of the epoxy resin composition (12) was dissolved in 40 parts by mass of methylethyl ketone, the resultant solution contained insoluble matter at room temperature. Then, this solution was heated to 50°C. As a result, the insoluble matter was dissolved to obtain a completely homogenous solution. When this solution was stored at 25°C, no precipitate appeared for 17 days. Turbidity appeared at the 18th day with 0.5% by mass of insoluble matter. Similarly, a 60% by mass acetone solution of epoxy resin composition (12) was prepared homogeneously with no insoluble matter and turbidity appeared at the 9th day with a 0.7% by mass of insoluble matter.

[Comparative Example 4]

50 parts by mass of polyphenylene ether resin V and 50 parts by mass of a bisphenol Type A epoxy resin (AER 260 manufactured by Asahi Kasei Corporation) were heated to 130°C, thereby melting and mixing them. To the resultant mixture, one part by mass of a 1% by mass sodium methylate/methanol solution was added and stirred until homogenized. After 5 minutes, the temperature of the molten product was increased to 190°C and stirred for 2 hours to obtain an epoxy resin composition (13).

The epoxy resin composition (13) had an epoxy equivalent of 453 and a melt viscosity of 12,000 mPa·s at 180°C. The amount of terminal phenolic hydroxyl group was 4.2 meq/kg. The content of unreacted epoxy quantified by gel permeation chromatography was 42 parts by mass based on the charged amount of 100 parts by mass. Accordingly, the proportion of the epoxylated polyphenylene ether resin was 58 parts by mass. When the content of terminal phenolic hydroxyl group per kg of the epoxylated polyphenylene ether resin was calculated, it was 7.2 meq/kg.

When 60 parts by mass of the epoxy resin composition (13) was dissolved in 40 parts by mass of methylethyl ketone, the resultant solution contained insoluble matter at room temperature. Then, this solution was heated to 50°C. As a result, the insoluble matter was dissolved to obtain a completely homogenous solution. When this solution was stored at 25°C, no precipitate appeared for 4 days. Turbidity appeared at the 5th day with 0.5% by mass of insoluble matter. Similarly, a 60% by mass acetone solution of the epoxy resin composition (13) was prepared homogeneously with no insoluble matter and turbidity appeared at 2nd day with a 0.7% by mass of insoluble matter.

[Comparative Example 5]

The same method as Example 9 was repeated except that polyphenylene ether V was used to obtain an epoxy resin composition (14). The obtained epoxy resin composition (14) had an epoxy equivalent of 362, and a melt viscosity of 114,000 mPa·s at 180°C. The amount of terminal phenolic hydroxyl group was 0.5 meq/kg. The content of unreacted epoxy quantified by gel permeation chromatography was 40 parts by mass based on the starting amount of 100 parts by mass. Accordingly, the proportion of the epoxylated polyphenylene ether resin was 60 parts by mass. When the content of terminal phenolic hydroxyl group per kg of the epoxylated polyphenylene ether resin was calculated, it was 0.83 meq/kg.

When 60 parts by mass of the epoxy resin composition (14) was dissolved in 40 parts by mass of methylethyl ketone, the resultant solution contained insoluble matter at room temperature. Then, this solution was heated to 50°C. As a result, the insoluble matter was dissolved to obtain a completely homogenous solution. When this solution was stored at 25°C, no precipitate appeared for 17 days. Turbidity appeared at the 18th day with 0.7% by mass of insoluble

matter. Similarly, a 60% by mass acetone solution of epoxy resin composition (14) was prepared homogeneously with no insoluble matter and turbidity appeared at the 19th day with a 0.9% by mass of insoluble matter.

10 g of the epoxy resin composition (14) was dissolved in 100 g of toluene and methanol was added thereto in a greatly excessive amount so as to precipitate epoxylated polyphenylene ether resin VI. The obtained epoxylated polyphenylene ether resin VI had a molecular weight of 11,400 and an epoxy equivalent of 1,960. Accordingly, the proportion of polyphenylene ether skeleton of the epoxylated polyphenylene ether resin was 60% by mass and the number of epoxy groups per molecule was 5.8.

[Comparative Example 6]

The same method as Example 9 was repeated except that polyphenylene ether VII was used to obtain an epoxy resin composition (15). The obtained epoxy resin composition (15) had an epoxy equivalent of 401, and a melt viscosity of 49,000 mPa·s at 180°C. The terminal phenolic hydroxyl group was 0.9 meq/kg. The content of unreacted epoxy quantified by gel permeation chromatography was 29 parts by mass based on the charged amount of 100 parts by mass. Accordingly, the proportion of the epoxylated polyphenylene ether resin was 71 parts by mass. When the content of terminal phenolic hydroxyl group per kg of the epoxylated polyphenylene ether resin was calculated, it was 1.3 meq/kg.

When 60 parts by mass of the epoxy resin composition (15) was dissolved in 40 parts by mass of methylethyl ketone, a completely homogenous solution was obtained without any insoluble matter. When this solution was stored at 25°C, no precipitate appeared for 90 days without insoluble matter. Similarly, a 40% by mass acetone solution of the epoxy resin composition (15) stored at 25°C produced no precipitate for 30 days or more.

10 g of the epoxy resin composition (15) was dissolved in 100 g of toluene and methanol was added thereto in a greatly excessive amount so as to precipitate epoxylated polyphenylene ether resin VII. The obtained epoxylated polyphenylene ether resin VII had a molecular weight of 3,030 and an epoxy equivalent of 510. Accordingly, the proportion of polyphenylene ether skeleton of the epoxylated polyphenylene ether resin was 36% by mass and the number of epoxy groups per molecule was 5.9.

When a copper clad laminate board was formed by using the epoxy resin composition (15), a dielectric constant of 4.5 at 1 MHz, a dielectric tangent of 0.015 (i.e., extremely poor electric properties), Tg by DSC of 175°C, and a copper foil peel strength of 1.50 kgf/cm. The cured product had no phase separation. After a solvent resistance test, no change was observed in the copper clad laminate board.

[Comparative Example 7]

The same method as Example 9 was repeated except that 2 g of a cresol novorak type epoxy resin (ECN 1299 manufactured by Asahi Kasei Epoxy Co., Ltd.) and 58 g of a bisphenol type A epoxy resin (A250 manufactured by Asahi Kasei Epoxy Co., Ltd.) were used to obtain an epoxy resin composition (16).

The epoxy resin composition (16) had an epoxy equivalent of 490, and a melt viscosity of 4,500 mPa·s at 180°C. The amount of terminal phenolic hydroxyl groups was 2.7 meq/kg. The content of unreacted epoxy quantified by gel permeation chromatography was 31 parts by mass based on the charged amount of 100 parts by mass. Accordingly, the proportion of the epoxylated polyphenylene ether resin was 69 parts by mass. When the content of terminal phenolic hydroxyl group per kg of the epoxylated polyphenylene ether resin was calculated, it was 3.9 meq/kg.

When 60 parts by mass of the epoxy resin composition (16) was dissolved in 40 parts by mass of methylethyl ketone, a completely homogenous solution was obtained without any insoluble matter. When this solution was stored at 25°C, no precipitate appeared for 30 days or more without any insoluble matter. Similarly, a 40% by mass acetone solution of the epoxy resin composition A stored at 25°C produced no precipitate for 30 days or more.

10 g of the epoxy resin composition (16) was dissolved in 100 g of toluene and methanol was added thereto in a greatly excessive amount so as to precipitate epoxylated polyphenylene ether resin VIII. The obtained epoxylated polyphenylene ether resin VIII had a molecular weight of 3,820 and an epoxy equivalent of 2,060. Accordingly, the proportion of polyphenylene ether skeleton of the epoxylated polyphenylene ether resin was 71% by mass and the number of epoxy groups per molecule was 1.85.

When a copper clad laminate board was formed by using the epoxy resin composition (16), it had a dielectric constant of 4.2 at 1 MHz, a dielectric tangent of 0.010, Tg by DSC of 165°C, and a copper foil peel strength of 1.39 kgf/cm. The cured product had phase separation. After a solvent resistance test, a blister of the copper clad laminate board was observed.

[Comparative Example 8]

The same method as Example 9 was repeated except that $NaOCH_3$ was added to the reaction system as a

catalyst and the heating temperature was set at 210 to 220°C to obtain an epoxy resin composition (17). The obtained epoxy resin composition (17) had an epoxy equivalent of 881, and a melt viscosity of 74,000 mPa·s at 180°C. The amount of terminal phenolic hydroxyl groups was 0.3 meq/kg. The content of unreacted epoxy quantified by gel permeation chromatography was 23 parts by mass based on the charged amount of 100 parts by mass. Accordingly, the proportion of the epoxylated polyphenylene ether resin was 77 parts by mass. When the content of terminal phenolic hydroxyl group per kg of the epoxylated polyphenylene ether resin was calculated, it was 0.4 meq/kg.

60 parts by mass of the epoxy resin composition (17) was dissolved in 40 parts by mass of methylethyl ketone, a completely homogenous solution was obtained without any insoluble matter. When this solution was stored at 25°C, no precipitate appeared for 30 days or more without any insoluble matter. Similarly, a 40% by mass acetone solution of the epoxy resin composition A stored at 25°C produced no precipitate for 30 days or more.

10 g of the epoxy resin composition (17) was dissolved in 100 g of toluene and methanol was added thereto in a greatly excessive amount so as to precipitate epoxylated polyphenylene ether resin IX. The obtained epoxylated polyphenylene ether resin IX had a molecular weight of 9,460 and an epoxy equivalent of 2,080. Accordingly, the proportion of polyphenylene ether skeleton of the epoxylated polyphenylene ether resin was 28% by mass and the number of epoxy groups per molecule was 3.8.

When a copper clad laminate board was formed by using the epoxy resin composition (17), it had a dielectric constant of 4.5 at 1 MHz, a dielectric tangent of 0.014 (i.e., extremely poor electric properties), Tg by DSC of 177°C, and a copper foil peel strength of 1.49 kgf/cm. The cured product had no phase separation. After a solvent resistance test, no change was observed in the copper clad laminate board.

[Example 10]

75% by mass of the epoxy resin composition (11) and 25% by mass of a brominated epoxy resin (AER8018 manufactured by Asahi Kasei Epoxy Co., Ltd.) were melt-blended. The epoxy resin composition (18) had a melt viscosity of 21,000 mPa·s at 180°C

[Example 11]

75% by mass of the epoxy resin composition (11), 5% by mass of an epoxy resin having an oxazolidone ring (AER4152 manufactured by Asahi Kasei Epoxy Co., Ltd.) and 20% by mass of a brominated epoxy resin (AER8018 manufactured by Asahi Kasei Epoxy Co., Ltd.) were melt-blended. The epoxy resin composition (19) had a melt viscosity of 18,000 mPa·s at 180°C.

[Example 12]

75% by mass of the epoxy resin composition (11), 3% by mass of an epoxy resin containing an oxazolidone ring (AER4152 manufactured by Asahi Kasei Epoxy Co., Ltd.), 12% by mass of an epoxylated phosphazene compound (SPG100 manufactured by Otsuka Chemical Co., Ltd.) and 10% by mass of a phosphate ester compound (PX200, manufactured by Daihachi Chemical Industry Co., Ltd.) were melt-blended. The epoxy resin composition (20) thus obtained had a melt viscosity of 19,000 mPa·s at 180°C.

[Example 13]

100 parts by mass of polyphenylene ether I, 100 parts by mass of AER 260, and 5 parts by mass of cage-form silsesquioxane I represented by the following formula (20) were melt-blended. The epoxy resin composition (21) thus obtained had a melt viscosity of 720 mPa·s at 180°C. When 130% by mass of methylethyl ketone was added to the composition, the solution contained no insoluble matter.

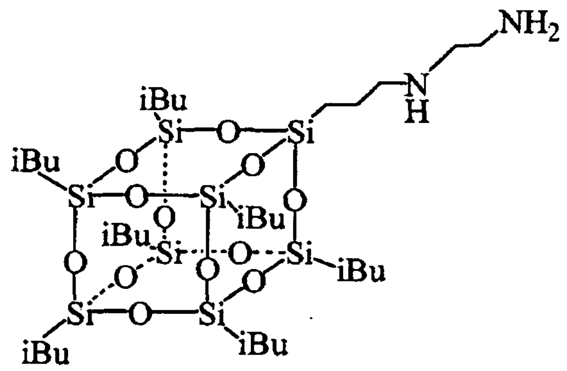

(20)

[Example 14]

100 parts by mass of the epoxy resin composition (6) and 5 parts by mass of a partially cleaved structure II of a cage-form silsesquioxane represented by the following formula (21) were melt-blended. The epoxy resin composition (22) thus obtained had a melt viscosity of 980 mPa·s at 180°C. When 40 parts by mass of methylethyl ketone was added to the composition and dissolved, the solution contained no insoluble matter.

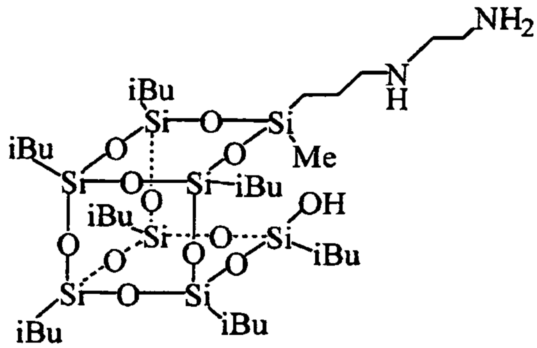

(21)

The properties of the laminate boards formed from epoxy resin composition solutions obtained in Examples 1 to 3 are shown in Table 1.

[Table 1]

| | Example 1 | Example 2 | Example 3 |
|---|---|---|---|
| Epoxy resin composition | (1) | (2) | (3) |
| Polyphenylene ether I (Part by weight) | 100 | | |
| Polyphenylene ether II (Part by weight) | | 100 | |
| Polyphenylene ether III (Part by weight) | | | 100 |
| AER260 (Part by weight) | 100 | 100 | 100 |
| Properties of copper clad laminate board | | | |
| Dielectric constant (@1MHz) | 4.2 | 4.5 | 4.2 |

Table continued

| Properties of copper clad laminate board | | | |
|---|---|---|---|
| Dielectric tangent (@1MHz) | 0.010 | 0.008 | 0.009 |
| Tg(°C) | 155 | 157 | 143 |
| Bending strength | 220 | 250 | 105 |
| Copper foil peel strength (Kgf/cm) | 0.55 | 0.57 | 0.35 |

The properties of copper clad laminate boards formed from the epoxy resin composition solutions obtained in Examples 4 to 9 and Comparative Examples 6 to 8 are shown in Table 2. To the epoxy resin composition solutions obtained in Examples 4 to 9 and Comparative Examples 6 to 8, dicyandiamide as a curing agent and 2-methylimidazole as a curing catalyst were added to prepare epoxy resin varnishes. Then, each of the epoxy resin varnishes was cast on a glass plate without impregnating glass cloth with it, cured at 150°C for 3 hours, further cured at 200°C for 3 hours, and subjected to the light diffusion measurement. The results are also shown in Table 2.

[Table 2]

| | | Example 4 | Example 5 | Example 6 | Example 7 | Example 8 | Example 9 |
|---|---|---|---|---|---|---|---|
| Epoxy resin composition | | (6) | (7) | (8) | (9) | (10) | (11) |
| Properties of copper clad laminate board | Dielectric constant (@1MHz) | 4.3 | 3.9 | 4.0 | 4.3 | 4.4 | 3.9 |
| | Dielectric tangent (@1MHz) | 0.011 | 0.008 | 0.009 | 0.010 | 0.012 | 0.006 |
| | Tg (°C) | 165 | 163 | 166 | 155 | 163 | 190 |
| | Bending strength (MPa) | 420 | 480 | 380 | 240 | 400 | 460 |
| | Copper foil peel strength (Kgf/cm) | 0.88 | 0.78 | 0.86 | 0.40 | 0.85 | 1.47 |
| | Solvent resistance | × | × | × | × | × | ○ |
| | Diffusion maximum by light diffusion measurement | × | × | × | × | × | ○ |

Table 2 continued

| | | Comparative Example 6 | Comparative Example 7 | Comparative Example 8 |
|---|---|---|---|---|
| Epoxy resin composition | | (15) | (16) | (17) |
| Properties of copper clad laminate board | Dielectric constant (@1MHz) | 4.5 | 4.2 | 4.5 |
| | Dielectric tangent (@1MHz) | 0.015 | 0.010 | 0.014 |
| | Tg(°C) | 175 | 165 | 177 |
| | Bending strength (MPa) | 430 | 440 | 435 |
| | Copper foil peel strength (Kgf/cm) | 1.50 | 1.39 | 1.49 |
| | Solvent resistance | ○ | × | ○ |
| | Diffusion maximum by light diffusion measurement | ○ | × | ○ |

The properties of copper clad laminate boards formed from the epoxy resin composition solutions obtained in Examples 10 to 12 are shown in Table 3.

[Table 3]

| | Example 10 | Example 11 | Example 12 |
|---|---|---|---|
| Epoxy resin composition | (18) | (19) | (20) |
| Epoxy resin composition (11) (% by weight) | 75 | 75 | 75 |
| AER8018 (% by weight) | 25 | 20 | |
| AER4152 (% by weight) | | 5 | 3 |
| SPG100 (% by weight) | | | 12 |
| PX200 (% by weight) | | | 10 |
| Properties of copper clad laminate board | | | |
| Dielectric constant (@1MHz) | 4.0 | 4.1 | 4.1 |
| Dielectric tangent (@1MHz) | 0.008 | 0.009 | 0.009 |
| Tg(°C) | 190 | 189 | 167 |
| Bending strength (MPa) | 420 | 435 | 410 |
| Copper foil peel strength (Kgf/cm) | 1.39 | 1.55 | 1.21 |
| Solvent resistance | ○ | ○ | ○ |
| Diffusion maximum by light diffusion measurement | ○ | ○ | ○ |
| Flame resistance | V-0 | V-0 | V-0 |

The properties of copper clad laminate boards formed from the epoxy resin composition solutions obtained in Examples 13 and 14 are shown in Table 4.

[Table 4]

| | Example 13 | Example 14 |
|---|---|---|
| Epoxy resin composition | (21) | (22) |
| Polyphenylene ether I (Part by weight) | 100 | |

Table continued

| | Example 13 | Example 14 |
|---|---|---|
| AER260 (Part by weight) | 100 | |
| Epoxy resin composition (6) (Part by weight) | | 100 |
| Cage-form silsesquioxane I (Part by weight) | 5 | |
| Partially cleaved structure II of cage-form silsesquioxane (Part by weight) | | 5 |
| Properties of copper clad laminate board | | |
| Dielectric constant (@1MHz) | 4.3 | 4.4 |
| Dielectric tangent (@1MHz) | 0.011 | 0.012 |
| Tg(°C) | 148 | 162 |
| Bending strength (MPa) | 200 | 400 |
| Copper foil peel strength (Kgf/cm) | 0.87 | 0.95 |

INDUSTRIAL APPLICABILITY

The epoxy resin composition of the present invention can be used in various ways since it has advantages such as long-term stability to a ketone, excellent processability, and excellent dielectric properties. The composition is applicable to printed circuit boards and electronic apparatuses in the form of a varnish using a solvent, a prepreg formed by impregnating a substrate with the varnish, and a laminate board using the prepreg.

**Claims**

1. An epoxy resin composition comprising a polyphenylene ether having a number average molecular weight of 1,000 to 4,000 and containing components having a molecular weight of 20,000 or more determined by GPC in an amount of substantially 20% or less, and an epoxy resin.

2. An epoxy resin composition comprising a polyphenylene ether having a number average molecular weight of 1,000 to 4,000 and substantially free of components having a molecular weight of 20,000 or more determined by GPC, and an epoxy resin.

3. An epoxy resin composition comprising a polyphenylene ether having a number average molecular weight of 1,000 to 4,000 and substantially free of components having a molecular weight of 300 or less determined by GPC, and an epoxy resin.

4. An epoxy resin composition comprising a polyphenylene ether having a number average molecular weight of 1,000 to 4,000 and substantially free of either components of a molecular weight of 20,000 or more or of 300 or less determined by GPC, and an epoxy resin.

5. The epoxy resin composition according to any one of claims 1 to 4, wherein the polyphenylene ether comprises not less than 1.2 phenolic hydroxyl groups per molecule in average.

6. The epoxy resin composition according to any one of claims 1 to 5, wherein the epoxy resin contains a multifunctional epoxy resin in an amount of 5% by mass or more.

7. A ketone solution of an epoxy resin composition comprising the epoxy resin composition according to any one of claims 1 to 6 in an amount of 10% by mass or more and substantially no solid matter at room temperature.

8. An epoxylated polyphenylene ether resin obtained by reacting a phenolic hydroxyl group of a polyphenylene ether having a number average molecular weight of 1,000 to 4,000 with an epoxy group of an epoxy compound or an epoxy resin.

9. An epoxylated polyphenylene ether resin having not less than 3 epoxy groups per molecule in average.

10. An epoxylated polyphenylene ether resin having a number average molecular weight of 3,200 to 10,000.

11. An epoxylated polyphenylene ether resin having a polyphenylene ether skeleton in a proportion of 30% by mass to 90% by mass.

12. The epoxylated polyphenylene ether resin according to claim 10 or 11, having not less than 3 epoxy groups per molecule in average.

13. The epoxylated polyphenylene ether resin according to claim 11, having a number average molecular weight of 3,200 to 10,000.

14. An epoxylated polyphenylene ether resin having not less than 3 epoxy groups per molecule in average, a number average molecular weight of 3,200 to 10,000, and a polyphenylene ether skeleton in a proportion of 30% by mass to 90% by mass.

15. The epoxylated polyphenylene ether resin according to any one of claims 8 to 14, wherein a phenolic hydroxyl group of the epoxylated polyphenylene ether resin is 10 meq/kg or less.

16. An epoxy resin composition comprising the epoxylated polyphenylene ether resin according to any one of claims 8 to 14 and an epoxy resin.

17. An epoxy resin composition comprising the epoxylated polyphenylene ether resin according to any one of claims 8 to 14 and an epoxy resin, and being soluble in a ketone.

18. A ketone solution of an epoxy resin composition comprising the epoxy resin composition according to claim 16 in an amount of 10% by mass or more and substantially by no solid matter at room temperature.

19. The epoxy resin composition according to claim 16, comprising the epoxylated polyphenylene ether resin in an amount of 25% by mass or more.

20. An epoxy resin composition comprising the epoxy resin composition according to claim 16 and, as a flame resistant agent, at least one selected from the group consisting of brominated epoxy resins, phosphazene compounds containing an epoxy group, phosphate esters, condensed phosphate esters, and quinine derivatives of a phosphine compound.

21. The epoxy resin composition according to claim 20, comprising the epoxylated polyphenylene ether resin in an amount of 40 to 90% by mass, the flame resistant agent in an amount of 10 to 50% by mass, and the epoxy resin in an amount of 0.1 to 30% by mass.

22. The epoxy resin composition according to claim 20 or 21, wherein the epoxy resin includes an epoxy resin having an oxazolidone ring.

23. The epoxy resin composition according to any one of claims 1 to 7, 16, and 19 to 22, further comprising at least one of a cage-form silsesquioxane and a partially cleaved cage-form silsesquioxane.

24. The epoxy resin composition according to any one of claims 1 to 7, 16, and 19 to 22, further comprising a curing agent for the epoxy resin.

25. A cured product comprising the epoxy resin composition according to claim 24 being homogeneous and having substantially no phase separation.

26. An epoxy resin composition comprising the epoxylated polyphenylene ether resin according to any one of claims 8

to 14 and further a curing agent for the epoxy resin.

**27.** An electronic member comprising the epoxy resin composition according to claims 1 to 7, 16, 17, and 19 to 25 selected from the group consisting of a resin varnish, prepreg, curable resin/metal foil composite, film, laminate board, multilayer printed wiring board, sealing resin composition, and curable resin composition for an adhesive agent.

**28.** An electronic member comprising the epoxylated polyphenylene ether resin according to any one of claims 8 to 14 selected from a resin varnish, prepreg, curable resin/metal foil composite, film, laminate board, multilayer printed wiring board, sealing resin composition, and curable resin composition for an adhesive agent.

**29.** An electronic apparatus comprising the electronic member according to claim 27 or 28.

**30.** A method of producing an epoxylated polyphenylene ether resin comprising reacting a phenolic hydroxyl group of a polyphenylene ether having a number average molecular weight of 1,000 to 4,000 with an epoxy group of an epoxy compound or an epoxy resin.

**INTERNATIONAL SEARCH REPORT**

International application No.
PCT/JP2004/006943

A. CLASSIFICATION OF SUBJECT MATTER
Int.Cl⁷ C08L63/00

According to International Patent Classification (IPC) or to both national classification and IPC

B. FIELDS SEARCHED

Minimum documentation searched (classification system followed by classification symbols)
Int.Cl⁷ C08L63/00-63/10

Documentation searched other than minimum documentation to the extent that such documents are included in the fields searched

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| P,X | JP 2004-59703 A (Matsushita Electric Works, Ltd.), 26 February, 2004 (26.02.04), Full text (Family: none) | 1-21,24-30 |
| P,X | JP 2003-292570 A (Mitsubishi Gas Chemical Co., Inc.), 15 October, 2003 (15.10.03), Full text & US 2003/194562 A1 | 8,10-11,13, 15 |
| X<br>Y | JP 2001-261791 A (Matsushita Electric Works, Ltd.), 26 September, 2001 (26.09.01), Full text (Family: none) | 1-7,24,27-30<br>23 |

[X] Further documents are listed in the continuation of Box C. [ ] See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 10 August, 2004 (10.08.04) | 24 August, 2004 (24.08.04) |
| Name and mailing address of the ISA/ Japanese Patent Office | Authorized officer |
| Facsimile No. | Telephone No. |

Form PCT/ISA/210 (second sheet) (January 2004)

**INTERNATIONAL SEARCH REPORT**

International application No.
PCT/JP2004/006943

C (Continuation). DOCUMENTS CONSIDERED TO BE RELEVANT

| Category* | Citation of document, with indication, where appropriate, of the relevant passages | Relevant to claim No. |
|---|---|---|
| X<br>Y | JP 2002-220436 A (Matsushita Electric Works, Ltd.),<br>09 August, 2002 (09.08.02),<br>Full text<br>(Family: none) | 1-7,24,27-30<br>23 |
| X<br><br>Y | JP 9-235349 A (Matsushita Electric Works, Ltd.),<br>09 September, 1997 (09.09.97),<br>Full text<br>(Family: none) | 8,10-11,13,<br>15-19,24-30<br>9,12,14,<br>20-23 |
| X<br>Y | JP 10-279781 A (Matsushita Electric Works, Ltd.),<br>20 October, 1998 (20.10.98),<br>Full text<br>(Family: none) | 9-15<br>9,12,14 |
| Y | JP 2002-308965 A (Asahi Kasei Epoxy Kabushiki Kaisha),<br>23 October, 2002 (23.10.02),<br>Full text<br>(Family: none) | 22 |
| Y | JP 2003-119253 A (Asahi Kasei Epoxy Kabushiki Kaisha),<br>23 April, 2003 (23.04.03),<br>Full text<br>(Family: none) | 22 |
| Y | JP 52-141899 A (Matsushita Electric Industrial Co., Ltd.),<br>26 November, 1977 (26.11.77),<br>Full text<br>(Family: none) | 23 |
| P,A | JP 2004-51904 A (Asahi Kasei Chemicals Corp.),<br>19 February, 2004 (19.02.04),<br>Full text<br>(Family: none) | 1-30 |

Form PCT/ISA/210 (continuation of second sheet) (January 2004)